# EUROPEAN PATENT SPECIFICATION

(11) **EP 3 951 608 B1**
(45) Date of publication and mention of the grant of the patent: **29.10.2025**
(21) Application number: 20832044.0
(22) Date of filing: 28.06.2020
(51) Int. Cl.: G06F 16/174, H03M 7/30

(54) **DATA COMPRESSION AND DATA DECOMPRESSION METHODS FOR ELECTRONIC DEVICE, AND ELECTRONIC DEVICE**
DATENKOMPRESSION UND DATENDEKOMPRIMIERUNGSVERFAHREN FÜR ELEKTRONISCHE VORRICHTUNG UND ELEKTRONISCHE VORRICHTUNG
PROCÉDÉS DE COMPRESSION DE DONNÉES ET DE DÉCOMPRESSION DE DONNÉES POUR DISPOSITIF ÉLECTRONIQUE, ET DISPOSITIF ÉLECTRONIQUE

(30) Priority: 28.06.2019 CN 201910579295
(43) Date of publication of application: 09.02.2022
(73) Proprietor: Huawei Technologies Co., Ltd., Shenzhen, Guangdong 518129 (CN)
(72) Inventor: ZHAO, Dongwei, Shenzhen, Guangdong 518129 (CN); HE, Huan, Shenzhen, Guangdong 518129 (CN); LIU, Qin, Shenzhen, Guangdong 518129 (CN)
(74) Representative: Gill Jennings & Every LLP
(86) International application number: PCT/CN2020/098614
(87) International publication number: WO 2020/259704

(56) References cited:
- CN-A- 1 928 850
- CN-A- 101 400 083
- CN-A- 103 078 646
- CN-A- 104 636 377
- US-A1- 2006 106 870
- US-A1- 2012 268 298
- US-B1- 7 643 505
- ANONYMOUS: "Robust Header Compression", WIKIPEDIA, 1 April 2019 (2019-04-01), pages 1 - 6, XP055919177, Retrieved from the Internet <URL:https://en.wikipedia.org/w/index.php?title=Robust_Header_Compression&oldid=890433733> [retrieved on 20220509]
- KHALED Q. ABDELFADEEL ET AL: "LSCHC : Layered Static Context Header Compression for LPWANs", PROCEEDINGS OF THE 12TH WORKSHOP ON CHALLENGED NETWORKS , CHANTS '17, 20 October 2017 (2017-10-20), New York, New York, USA, pages 13 - 18, XP055505241, ISBN: 978-1-4503-5144-7, DOI: 10.1145/3124087.3124092
- MINABURO ACKLIO L TOUTAIN INSTITUT MINES TELECOM A ET AL: "LPWAN Static Context Header Compression (SCHC) for IPv6 and UDP; draft-toutain-lpwan-ipv6-static-context-hc-00.txt", LPWAN STATIC CONTEXT HEADER COMPRESSION (SCHC) FOR IPV6 AND UDP; DRAFT-TOUTAIN-LPWAN-IPV6-STATIC-CONTEXT-HC-00.TXT, INTERNET ENGINEERING TASK FORCE, IETF; STANDARDWORKINGDRAFT, INTERNET SOCIETY (ISOC) 4, RUE DES FALAISES CH- 1205 GENEVA, SWITZERLAND, 23 September 2016 (2016-09-23), pages 1 - 14, XP015115409, [retrieved on 20160923]

## Description

### TECHNICAL FIELD

This application relates to the field of computer technologies, and in particular, to a data compression method and a data decompression method for an electronic device, and an electronic device.

### BACKGROUND

At present, a quantity of narrowband IoT (narrowband Internet of Things, NB-IoT) sensor devices (which may be referred to as internet of thing devices for short) has exceeded that of smartphones, personal computers, or the like. To reduce overheads caused by data storage and receiving/sending, an internet of things device usually uses a data compression and decompression function. However, with a rapid increase in an application scale and increasing requirements of manufacturers for low power consumption and long standby time, it is more difficult for an existing compression and decompression technology to satisfy the requirements.

Currently, there are two common compression and decompression methods as follows:

In a first method, through packet header compression (robust header compression, ROHC), an unchanged part of data is recorded by taking advantage of a feature that some fields in the data remain unchanged during transmission, and a changed part of the data is compressed and transmitted. In a subsequent decompression process, the received changed data and the unchanged part are spliced to complete data decompression.

In a second method, data is compressed by using either of two types of lossless text compression algorithms that are based on dictionary compression and statistical compression.

However, in the foregoing two methods, a size of compressed data is still relatively large, resulting in relatively high overheads caused by data storage and receiving/sending.

Anonymous, "Robust Header Compression", Wikipedia, (20190401), pages 1 - 6, URL: https://en.wikipedia.org/w/index.php?title=Robust_Header_Compression&oldid=890433733, describes robust header compression

KHALED Q. ABDELFADEEL ET AL, "LSCHC : Layered Static Context Header Compression for LPWANs", PROCEEDINGS OF THE 12TH WORKSHOP ON CHALLENGED NETWORKS , CHANTS '17, New York, New York, USA, (20171020), doi:10.1145/3124087.3124092, ISBN 978-1-4503-5144-7, pages 13 - 18, describes layered static context header compression for LPWANs.

US7643505B1 relates to method and system for real time compression and decompression. US2006106870A1 relates to data compression using a nested hierarchy of fixed phrase length dictionaries.

MINABURO A., TOUTAIN L., INSTITUT MINES TELECOM A ET AL: "LPWAN Static Context Header Compression (SCHC) for IPv6 and UDP; draft-toutain-lpwan-ipv6-static-context-hc-00.txt", LPWAN STATIC CONTEXT HEADER COMPRESSION (SCHC) FOR IPV6 AND UDP; DRAFT-TOUTAIN-LPWAN-IPV6-STATIC-CONTEXT-HC-00.TXT, INTERNET ENGINEERING TASK FORCE, IETF; STANDARDWORKINGDRAFT, INTERNET SOCIETY (ISOC) 4, RUE DES FALAISES CH- 1205 GENEVA, SWITZERLAND, 23 September 2016 (2016-09-23) describes certain details of Static Context Header Compression (SCHC).

### SUMMARY

This application provides a data compression method and a data decompression method for an electronic device, and an electronic device, to make a size of compressed data become smaller, so that overheads caused by data storage and receiving/sending are reduced.

The invention has been defined in the independent claims. Further specific technical features have been defined in the dependent claims.

### BRIEF DESCRIPTION OF DRAWINGS

FIG. 1 is a schematic diagram of an architecture of a system according to this application;
FIG. 2 is a flowchart of a data compression method for an electronic device according to this application;
FIG. 3 is a schematic diagram of a first rule according to this application;
FIG. 4 is a flowchart of a data decompression method for an electronic device according to this application;
FIG. 5 is a schematic diagram of a data compression procedure according to this application;
FIG. 6 is a schematic diagram of a data decompression procedure according to this application;
FIG. 7 is a schematic diagram of a compressed storage structure according to this application;
FIG. 8 is a schematic diagram of performing compression processing on to-be-compressed data to obtain compressed data according to this application;
FIG. 9 is a schematic diagram of performing decompression processing on to-be-compressed data to obtain decompressed data according to this application;
FIG. 10 is a schematic diagram of a structure of an electronic device according to this application;
FIG. 11 is a schematic diagram of a structure of another electronic device according to this application;
FIG. 12 is a diagram of a structure of an electronic device according to this application; and
FIG. 13 is a diagram of a structure of another electronic device according to this application.

### DESCRIPTION OF IMPLEMENTATIONS

To make the objectives, technical solutions, and advantages of this invention clearer, the following further describes various implementations in detail with reference to the accompanying drawings. The implementations described below are not all claimed, they are included to help understanding the context of the invention. While the description refers to various implementations, the embodiments of the invention are those which comprise at least all the features of an independent claim. Any implementation which does not fall within the scope of the claims does not form part of the invention, but rather included as an illustrative example that is useful for understanding the invention.

Implementations of this application provide a data compression method and a data decompression method for an electronic device, and an electronic device, to make a size of compressed data become smaller, so that overheads caused by data storage and receiving/sending are reduced. The methods and the apparatus in this application are based on a same inventive concept. The methods and the apparatus have similar problem resolving principles. Therefore, for implementation of the apparatus and the methods, mutual reference may be made to each other. Details of repeated parts are not described.

In this application, "a plurality of" means two or more than two.

To describe technical solutions in the implementations of this application more clearly, with reference to the accompanying drawings, the following details the data compression method and the data decompression method for the electronic device, and the electronic device that are provided in the implementations of this application.

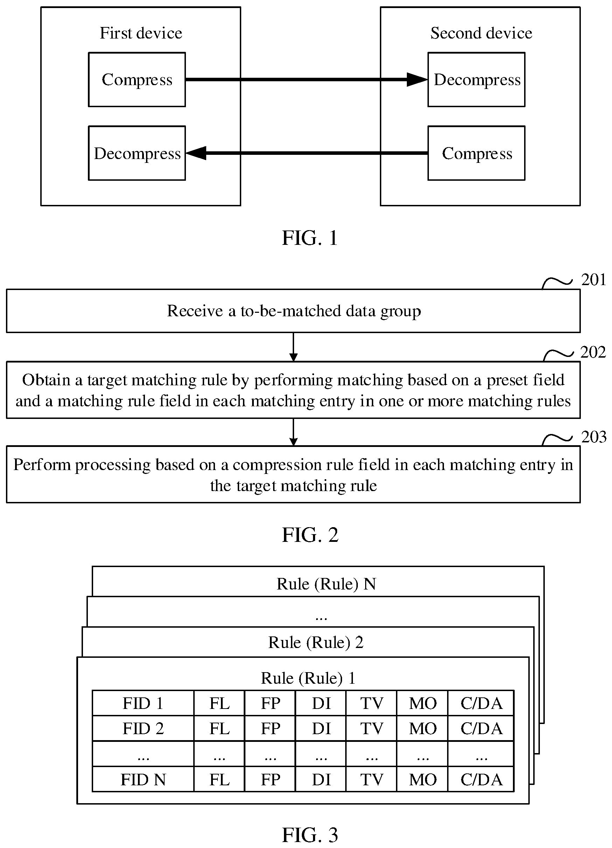

FIG. 1 shows a possible system architecture to which a data compression method and a data decompression method for an electronic device are applicable according to an implementation of this application. The system architecture includes a first device and a second device.

Both the first device and the second device have a compression function and a decompression function. In a data transmission process between the first device and the second device, the first device compresses to-be-compressed data and transmits compressed data to the second device, and the second device receives the compressed data and performs decompression processing on the compressed data; or the second device performs compression processing on to-be-compressed data and transmits compressed data to the first device, and the first device receives the compressed data and performs decompression processing on the compressed data.

Both the first device and the second device are electronic devices. For example, the first device may be either an internet of things device or an internet device, and the second device may be the other one of the internet of things device and the Internet device other than the first device. The internet of things device may be a device that can be connected to a network, such as a sensor node, a household water meter or electricity meter, a fire alarm, an intelligent lock, or a surveillance camera. The internet device may be a device such as a communications base station.

Certainly, when the first device or the second device is an internet of things device, the internet of things device may be replaced with a terminal device. Specifically, the terminal device may be a mobile phone, a notebook computer, a set top box, or the like.

The data compression method for the electronic device provided in the implementations of this application is applicable to the system shown in FIG. 1. In the method, the electronic device includes a processor and a memory. The memory stores one or more matching rules. Each matching rule includes one or more matching entries, each matching entry is used to perform matching on to-be-matched data in a to-be-matched data group, the to-be-matched data group includes one or more pieces of to-be-matched data, and each piece of to-be-matched data includes one or more bits of data. Each matching entry includes: a preset field; a matching rule field, used to indicate to perform matching between first data in to-be-matched data and the preset field according to a specific rule; and a compression rule field, used to indicate, based on a matching result that is obtained through matching by using the matching rule field, that data is not to be sent or that one or more bits are to be sent. When one or more bits are indicated to be sent, the one or more bits are one or more bits corresponding to the preset field. Refer to FIG. 2. A specific procedure of the method includes the following steps.

Step 201: Receive a to-be-matched data group.

Step 202: Obtain a target matching rule by performing matching based on the preset field and the matching rule field in each matching entry in the one or more matching rules.

Step 203: Perform processing based on a compression rule field in each matching entry in the target matching rule.

During specific implementation, each matching entry further includes one or more data feature fields, and each data feature field is used to indicate a data feature of the first data in the to-be-matched data.

In an implementation, each matching entry may further include a decompression rule field, used to indicate, based on the matching result that is obtained through matching by using the matching rule field, to restore the preset field or to restore original data corresponding to second data. The second data is any piece of to-be-decompressed data in a to-be-decompressed data group, and the second data is the one or more bits corresponding to the preset field. The method further includes: receiving a to-be-decompressed data group, determining the target matching rule from the one or more matching rules, and performing processing based on a preset field, a matching rule field, and a decompression rule field in each matching entry in the target matching rule.

Due to different manufacturers of electronic devices and different data formats of the different manufacturers, in an optional implementation, the one or more matching rules may be encoding rules customized by corresponding manufacturers of the electronic devices, and are preconfigured in the electronic devices. The one or more matching rules may specifically be in a tabular form, as shown in FIG. 3.

For example, the one or more matching sub-rules may be a rule (rule) 1, a rule 2, ..., and a rule N shown in FIG. 3, where N is an integer greater than or equal to 1. One or more matching entries included in each matching rule may be one or more rows in the rule shown in FIG. 3, where one row may be considered as one matching entry. One or more data feature fields included in each matching entry may be one or more of fields shown in FIG. 3: a field identifier (field ID, FID), a field length (field length, FL), a field position (field position, FP), a direction identifier (direction identifier, DI), and the like. The preset field may be a target value (target value, TV) shown in FIG. 3. The matching rule field may be a field configurable rule operation method (matching operator, MO) shown in FIG. 3. The compression rule field and the decompression rule field may be combined into one field, or may be two separate fields, for example, may be a field configurable compression/decompression action (compress/decompress action, C/DA) shown in FIG. 3. The following describes use of required fields and optional fields in each matching entry.

Optional fields are as follows:
(1) An FID is a unique value used to define a data field type. For example, for a network packet type, the data field type may be IPv4 or IPv6; and for a sensor, the data field type may be global positioning system (global positioning system, GPS) coordinates, an ambient temperature, or atmospheric pressure.
(2) An FL is a quantity of bytes used to indicate matching, so that a peer device can restore data based on the length during subsequent decompression.
(3) A TV is a target value used for numeral matching, for example, a floating-point number of a temperature or atmospheric pressure, a keyword set, or a parameter of a calculation formula.
(4) An MO is used to define a matching manner between a field value (field value, FV) of data and a TV, and an operation result of the MO is true (matched) or false (not matched). For example, the MO defines a full match if an FV is a target value 1.23 of a temperature or atmospheric pressure, or a partial match if an integer part of an FV is equal to an integer part of 1.23; querying for a field value in a target value list; or a matching calculation formula (specific calculation manner) based on a field value and a target value. Examples of MOs may be listed in Table 1:

**Table 1**

| Examples of MOs | Description |
|---|---|
| Equal | The result is True if an FV in a data packet is equal to a TV in a rule. |
| Ignore | The result is always True, and no check is performed. |
| Comparison of highest x bits | The result is True if highest x bits of an FV in a data packet are equal to those of a TV in a rule, where the parameter x is a compared length. |
| Matching mapping | A TV is a list of values, where each value in the list is identified by a short ID. The result is True if an FV is equal to one of the values in the target value list. |

(5) C/DA: When an associated configurable rule operation method returns True, each configurable compression/decompression action is performed. The following provides examples.

al. A compression device (for example, an electronic device that needs to compress data) sends only a numeral that is in a temperature or atmospheric pressure and that is not matched. A decompression device (for example, an electronic device that needs to decompress data) receives compressed data, and performs splicing by using the numeral that is not matched, to restore temperature or atmospheric pressure data.

a2. The compression device sends only a position of a field value in a target value list. The decompression device receives compressed data, and performs querying by using the position in the list, to restore data.

a3. The compression device sends only a target value parameter combination manner used for a matching calculation formula. The decompression device receives compressed data, obtains a parameter by using the target value parameter combination manner, and invokes the calculation formula to restore data.

For example, C/DAs corresponding to different MOs may be listed in Table 2:

**Table 2**

| Examples of compression and decompression methods | MO | CA | DA |
|---|---|---|---|
| Not send | Equal | Not send | Using a value stored in a TV |
| Value sending | Ignore | Send | Using a received value |
| Mapping and sending | Matching mapping | Sending an index (index) | Using a value corresponding to an index in a shared table |
| Lowest y bits | Highest x bits compared are equal. | Sending the lowest y bits | Splicing a TV value and the lowest y bits (bit) |

Optional fields are as follows:
An FP is used to indicate a sequence of a plurality of fields with a same name in some scenarios.

A DI is used to indicate a direction of a data packet in some scenarios. A value of the DI may be uplink, downlink, or bidirectional.

It should be noted that, the fields shown in FIG. 3 are merely used as an example, and other fields that are not shown may also exist in fields included in each matching entry. This is not specifically limited in this application.

In an optional implementation, the one or more bits corresponding to the preset field may include: one or more bits that are included in the preset field and that are corresponding to the first data. For example, the preset field, namely, the target value, includes a target value list, and the first data is equal to one value in the target value list. In this case, the one or more bits are an index of the matched value. Alternatively, the one or more bits corresponding to the preset field may include: one or more bits corresponding to the matching result that is obtained in a specific calculation manner corresponding to the preset field. For example, when the first data is 2, the preset field is 3, and the specific calculation manner corresponding to the preset field is a difference between the preset field and the first data, an obtained difference value is 1. In this case, the one or more bits are one or more bits corresponding to 1.

Specifically, the one or more bits corresponding to the preset field are bits representing a minimum quantity of bits of the first data. In this way, a size of compressed data becomes smaller.

In an example, the compression rule field indicates that data is not to be sent, and the matching result is that the first data is equal to the preset field; or the compression rule field indicates that one or more bits are to be sent, and the matching result is one of the following: the first data is equal to one of a plurality of pieces of preset data in the preset field, a part of the first data is equal to the preset field, and the first data and the preset field conform to the specific calculation manner.

Specifically, a to-be-matched data group is received, and when the target matching rule is obtained by performing matching based on the preset field and the matching rule field in each matching entry in the one or more matching rules, the one or more data feature fields in each matching entry also need to be used for performing matching. Specifically, matching may be successively performed between the to-be-matched data group and the one or more matching rules until the target rule is determined. A specific method may be: Each time matching is performed between the to-be-matched data group and one matching rule, the following operations are performed: successively performing matching between one or more pieces of to-be-matched data in the to-be-matched data group and one or more data feature fields, a preset field, and a matching rule field in one or more matching entries in a matching rule; and if it is determined that all to-be-matched data in the to-be-matched data group respectively matches the one or more data feature fields, the preset field, and the matching rule field in all matching entries in the matching rule, determining that the matching rule is the target rule; otherwise, performing matching between the one or more pieces of to-be-matched data in the to-be-matched data group and one or more data feature fields, a preset field, and a matching rule field in one or more matching entries in a next matching rule, until the target rule is determined.

According to the claimed invention, a compressed data group obtained after compression processing is performed based on the preset field, the matching rule field, and the compression rule field in each matching entry in the target matching rule includes an indication indicating whether to perform compression and an identifier of the target matching rule.

For example, in a case in which the fields included in each matching rule are shown in FIG. 3, a procedure for processing the received to-be-matched data group by using the foregoing method may be as follows:
b1. For the to-be-matched data group, obtain the one or more matching rules and to-be-matched data in the to-be-matched data group.
b2. For each matching rule, iterate each row (that is, a matching entry in the matching rule), and check whether a field identifier (FID) and a direction identifier (DI) in the to-be-matched data group respectively match those in the row.
b3. If the foregoing FIDs and DIs do not respectively match each other, check a next row (that is, a next matching entry); otherwise, continue to verify whether the to-be-matched data group matches a field position (FP) in the row.
b4. Because all fields in one matching rule need to respectively match all fields in the to-be-matched data group, and rows in the matching rule need to be sorted in a sequence in which the rows appear in the to-be-matched data, if the field positions are not corresponding to each other, skip using the matching rule, and check a next matching rule.
b5. If the field positions (FP) match each other, perform matching between a field value (FV) (that is, the first data) of the to-be-matched data and a target value (TV) stored in the row by using a corresponding configurable rule operation method (MO) corresponding to a matching rule field.
b6. If the FV matches the TV, use a next row to match a next data field; otherwise, skip the matching rule and restart the process by using a next matching rule.
b7. If all fields in the to-be-matched data satisfy all configurable rule operation methods of a matching rule, process the to-be-matched data group based on a configurable compression rule field of the matching rule.
b8. Finally generate a compression header including an ID of the target matching rule (one of the rule 1 to the rule N).

In an optional implementation, a "compression residual" may be generated (remaining description information that is based on the target matching rule and that is generated after the to-be-matched data group is processed, for example, index information indicative of a TV position, as listed in Table 2), followed by uncompressed data. If no target matching rule satisfying a condition is found, the to-be-matched data group needs to be sent without being compressed. For example, an output format of compressed data is referred to as a compressed storage structure.

Correspondingly, a same matching rule is used in a compression process and a decompression process. To be specific, when one electronic device sends compressed data to another electronic device, the one or more matching rules used by the one electronic device in a data processing process are also preconfigured in the another electronic device, so that the another electronic device can perform, by using the same rule, decompression processing on the compressed data received from the one electronic device.

In an optional implementation, a specific method for determining the target matching rule from the one or more matching rules may be: determining the target matching rule from the one or more matching rules based on the identifier of the target matching rule in the to-be-decompressed data group.

Specifically, when processing is performed based on the preset field, the matching rule field, and the decompression rule field in each matching entry in the target matching rule, the one or more data feature fields in each matching entry are also used for performing processing. A specific method may be: separately restoring, based on one or more data feature fields, the matching rule field, and the decompression rule field in each matching entry in the target matching rule, original data corresponding to the to-be-decompressed data group.

Corresponding to the foregoing procedure for processing the to-be-matched data group, a processing procedure for decompressing the to-be-decompressed data group may be as follows:
c1. Receive the to-be-decompressed data group, and obtain the ID of the target matching rule from the compression header of the to-be-decompressed data group.
c2. After the ID of the target matching rule is found, perform a decompression action in sequence for each row of the target matching rule, to obtain one or more pieces of original data. For example, a value in a TV, which may optionally be a "compression residual" or uncompressed data, may be used to restore original data.

It should be noted that decompressed data is the same as original data when there is no error, and is different from the original data when there is an error, but the error is within an allowable error range.

In a possible implementation, when the ID of the target matching rule is not found, uncompressed data is directly used without performing decompression processing.

It should be noted that, when decompressing data, any electronic device may decompress the data based only on some fields in the matching entry in the target matching rule. This is not limited in this application.

During specific implementation, the electronic device includes one or more interfaces, configured to receive one or more new matching rules; and the one or more new matching rules are configured based on a new service. In this way, the matching rule configured based on the new service can be flexibly configured in the electronic device, so that the electronic device satisfies a service requirement.

It is well known that, a conventional compression algorithm format or algorithm is fixed, and a calculation process of the algorithm cannot be defined by a user. In addition, a single type of data is corresponding to only a unique format, and consequently data types of various manufacturers are not compatible with each other. According to the method proposed in this application, a configurability issue on product customization or version update is resolved by using a method for customizing an encoding rule. In addition, compression is performed for a plurality of matching rules corresponding to a single type of data, so that a compatibility problem is resolved and compression efficiency is improved. Therefore, according to the method provided in this implementation of this application, data compression and decompression may be performed according to a preconfigured rule, so that algorithm compatibility is relatively desirable. The preconfigured rule may be customized depending on an actual case, is used relatively flexible and accurate, and has a precision control capability for data compression. Moreover, according to the method provided in this implementation of this application, a part of processed data is not sent on a basis of original data. In this way, a data volume can be obviously reduced, and a size of the processed data is relatively small, so that overheads caused by data storage and receiving/sending are reduced.

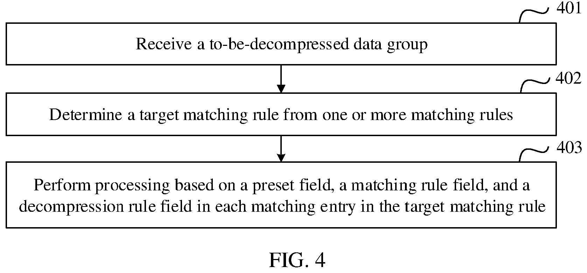

Based on the foregoing implementation, the data decompression method for the electronic device provided in the implementations of this application is applicable to the system shown in FIG. 1. In the method, the electronic device includes a processor and a memory. The memory stores one or more matching rules. Each matching rule includes one or more matching entries, and each matching entry is used to perform matching on to-be-decompressed data in a to-be-decompressed data group. Each matching entry includes: a preset field; a matching rule field, used to indicate to perform matching between first data in original data and the preset field according to a specific rule; and a decompression rule field, used to indicate, based on a matching result that is obtained through matching by using the matching rule field, to restore the preset field or to restore the original data corresponding to second data. The second data is any piece of to-be-decompressed data in the to-be-decompressed data group, and the second data is one or more bits corresponding to the preset field. Refer to FIG. 4. A specific procedure of the method includes the following steps.

Step 401: Receive a to-be-decompressed data group.

Step 402: Determine a target matching rule from the one or more matching rules.

Step 403: Perform processing based on a preset field, a matching rule field, and a decompression rule field in each matching entry in the target matching rule.

Specifically, each matching entry further includes one or more data feature fields, and each data feature field is used to indicate a data feature of the first data.

Specifically, descriptions of the fields in each matching entry are similar to the descriptions of the fields in each matching entry in the implementation shown in FIG. 2, and mutual reference may be made. Details are not described herein again.

In an implementation, the to-be-decompressed data includes an indication indicating whether to perform compression and an identifier of the target matching rule; and a specific method for determining a target matching rule from the one or more matching rules may be: determining the target matching rule from the one or more matching rules based on the identifier of the target matching rule in the to-be-decompressed data group.

A decompression processing procedure herein is similar to the decompression processing procedure in the implementation shown in FIG. 2, and mutual reference may be made. Details are not described herein again.

The one or more bits corresponding to the preset field may be: one or more bits that are included in the preset field and that are corresponding to the first data; or one or more bits corresponding to the matching result that is obtained in a specific calculation manner corresponding to the preset field.

For example, the one or more bits corresponding to the preset field are bits representing a minimum quantity of bits of the first data.

The one or more bits corresponding to the preset field herein are similar to the one or more bits corresponding to the preset field in the implementation shown in FIG. 2. For details, refer to related descriptions thereof. Details are not described herein again.

In an optional implementation, each matching entry further includes a compression rule field, used to indicate, based on the matching result that is obtained through matching by using the matching rule field, that data is not to be sent or that one or more bits are to be sent. When one or more bits are indicated to be sent, the one or more bits are the one or more bits corresponding to the preset field. The method further includes: receiving a to-be-matched data group, obtaining the target matching rule by performing matching based on the preset field and the matching rule field in each matching entry in the one or more matching rules, and performing processing based on a compression rule field in each matching entry in the target matching rule. The to-be-matched data group includes one or more pieces of to-be-matched data, each piece of to-be-matched data includes one or more bits of data, and the to-be-matched data includes the first data.

Specifically, the compression rule field indicates that data is not to be sent, and the matching result is that the first data is equal to the preset field; or the compression rule field indicates that one or more bits are to be sent, and the matching result is one of the following: the first data is equal to one of a plurality of pieces of preset data in the preset field, a part of the first data is equal to the preset field, and the first data and the preset field conform to the specific calculation manner.

A compression processing method herein is similar to the compression processing method in the implementation shown in FIG. 2, and mutual reference may be made. Details are not described herein again.

Specifically, the electronic device includes one or more interfaces, configured to receive one or more new matching rules; and the one or more new matching rules are configured based on a new service. In this way, the matching rule configured based on the new service can be flexibly configured in the electronic device, so that the electronic device satisfies a service requirement.

According to the method provided in this implementation of this application, the electronic device may restore original data according to a preconfigured matching rule and by performing a decompression method corresponding to a compression rule on data that needs to be decompressed. The use manner is relatively flexible and accurate.

It should be noted that one case may be as follows: In the foregoing two implementations, data compression and decompression processing may be required when the electronic device in the implementation shown in FIG. 2 and the electronic device in the implementation shown in FIG. 4 perform data transmission. A specific case may be as follows: After processing a data group according to the target matching rule, the electronic device in the implementation shown in FIG. 2 sends a compressed data group to the electronic device in the implementation shown in FIG. 4, and the electronic device in the implementation shown in FIG. 4 performs decompression processing still according to the target matching rule, to restore original data. Likewise, after processing a data group according to the target matching rule, the electronic device in the implementation shown in FIG. 4 sends a compressed data group to the electronic device in the implementation shown in FIG. 2, and the electronic device in the implementation shown in FIG. 2 performs decompression processing still according to the target matching rule, to restore original data.

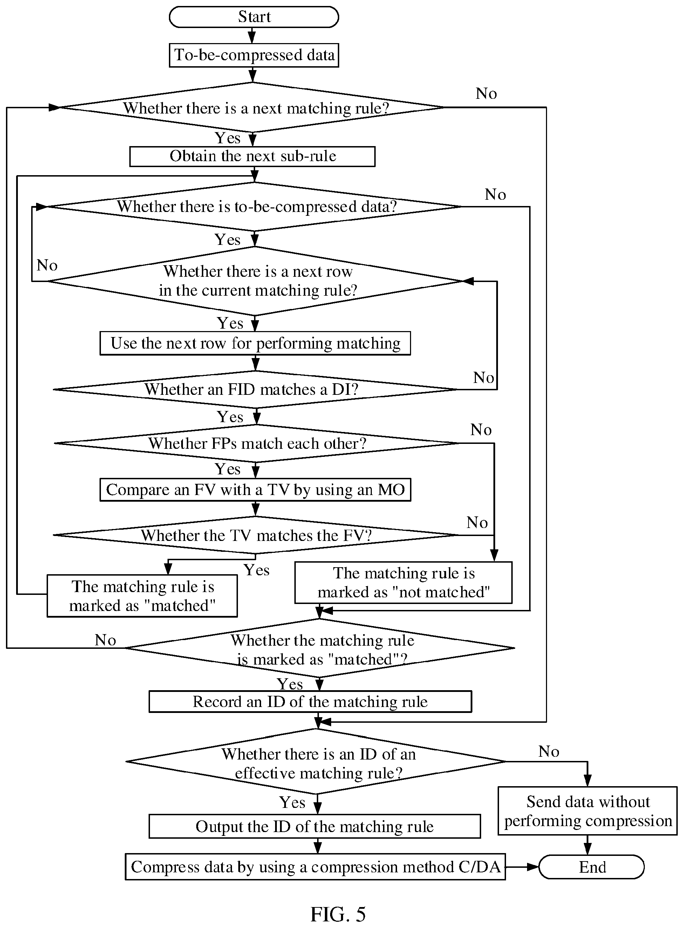

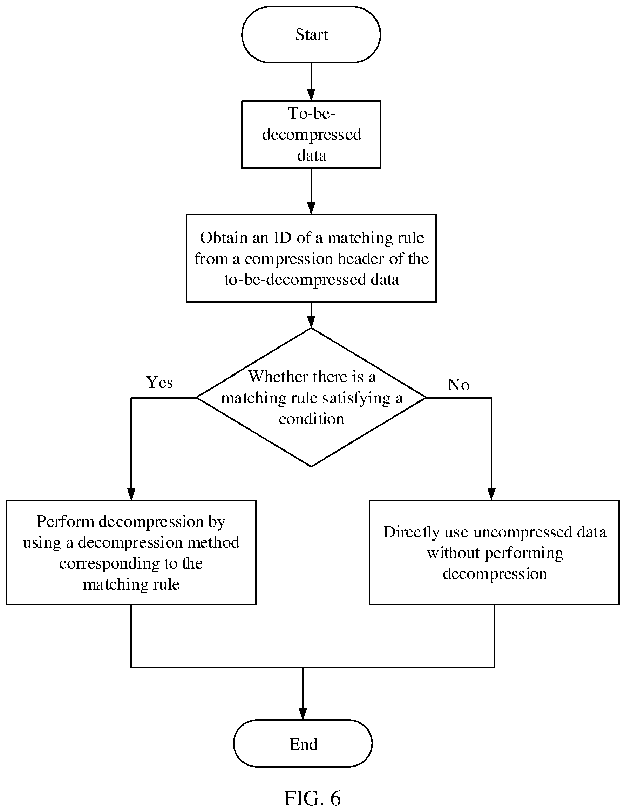

Based on the foregoing implementation, when an electronic device performs data compression, a compression processing procedure may be shown in FIG. 5; and correspondingly, when an electronic device performs data decompression, a decompression processing procedure may be shown in FIG. 6.

Specifically, in the compression processing procedure, when a matching rule is used for performing matching, full matching or partial matching may be performed. Partial matching may be corresponding to a row in the matching rule (for example, a configurable rule operation method is defined as making no comparison, and therefore a configurable compression action directly uses original data), or may not appear in the matching rule (for example, rows of the current matching rule have ended, and matching is not performed on following data). Partially matched data may be located at a header, middle, or trailer part of a data field.

The following uses an example in which a possible matching rule is designed for an IPv6 scenario for description. For example, the matching rule may be listed in Table 3. It should be noted that the matching rule may also be applied to other types of packet headers and data of a user datagram protocol (user datagram protocol, UDP), a constrained application protocol (constrained application protocol, CoAP), a transmission control protocol (transmission control protocol, TCP), a hypertext transfer protocol (hypertext transport protocol, HTTP), a real-time transport protocol (real-time transport protocol, RTP), and the like, and may further be applied to payload (Payload) data and the like. This is not limited in this application.

**Table 3**

| Scenario (protocol) | FID | FL | FP | DI | TV | MO | C/DA | #bits-sent |
|---|---|---|---|---|---|---|---|---|
| IPv6 | Version | 4 | 1 | Bi | 6 | equal | not-sent | |
| | Traffic class | 8 | 1 | Bi | 0 | equal | not-sent | |
| | Flow label | 20 | 1 | Bi | 0 | equal | not-sent | |
| | Payload length | 16 | 1 | Bi | - | ignore | Compute-IPv6-length | |
| | Next header | 8 | 1 | Bi | 17 | equal | not-sent | |
| | Hop limit | 8 | 1 | Bi | - | ignore | not-sent | |
| | Dev prefix | 64 | 1 | Bi | alpha/64 | equal | not-sent | |
| | Dev IID | 64 | 1 | Bi | abcd | equal | not-sent | |
| | APP prefix | 64 | 1 | Bi | beta/64 | equal | not-sent | |
| | APP IID | 64 | 1 | Bi | 1 | equal | not-sent | |

A field identifier (FID) is a unique value used to define a data field, for example, an IP version (Version in Table 3), and may also be used to specify other data features such as temperature data and update package data.

A direction identifier (DI) indicates a direction of a data packet and may have three values: uplink, downlink, and bidirectional.

Uplink (Up): This field is applicable to data sent by user equipment (user equipment, UE) to a packet data network (packet data network, PDN) gateway (P-GW), for example, a CoAP request code.

Downlink (Dw): This field is applicable to data sent by the PDN gateway to the user equipment, for example, a CoAP response code.

Bidirectional (Bi): This field is applicable to both uplink and downlink data, such as CoAP type data.

A field position (FP) is used to identify a duplicate field identifier (FID) in data and indicate which field is a target field (1 by default), for example, CoAP Uri-Path.

A configurable rule operation method (MO) is an operator used for comparing a field value (FV) of to-be-compressed data and a target value (TV). The MO may require some parameters and is only used in a compression process. The operator can be used to directly determine through comparison whether the FV is equal to the TV; or compare the FV with a list of one or more TVs to confirm whether the FV is equal to a TV in the list; or make no comparison; or directly determine through comparison whether highest x bits of the FV are equal to those of the TV; or compare the FV with a list of one or more TVs to confirm whether highest x bits of the FV are equal to those of a TV in the list; or directly determine through comparison whether lowest x bits of the FV are equal to those of the TV; or compare the FV with a list of one or more TVs to confirm whether lowest x bits of the FV are equal to those of a TV in the list.

A configurable compression/decompression action (C/DA) is used to describe compression and decompression processes. The C/DA may require some parameters and may be used in the compression and decompression processes. A configurable rule operation method is used in the compression process to compare a field value (FV) of to-be-compressed data and a TV value stored in each matching rule. When an associated configurable rule operation method returns True, each configurable compression action is performed. A compression device (an electronic device) and a decompression device (an electronic device) respectively compress data and perform decompression to restore an original value by using the configurable compression/decompression action. Examples of configurable compression/decompression actions are listed in Table 4.

**Table 4**

| Method name example | Rule method example | Compression method example | Decompression method example |
|---|---|---|---|
| Not send | Directly determining through comparison whether an FV is equal to a TV | Blanking | Using a value stored in the TV |
| Value sending | No comparison | Sending an FV | Using a received value |
| Mapping and sending | Comparing an FV with one or more lists including one or more TVs to confirm whether the FV is equal to a TV in the list | Sending an index | Using a value corresponding to an index in a shared table |
| Lowest y bits | Directly determining through comparison whether highest x bits of an FV are equal to those of a TV | Sending the lowest y bits | Splicing the TV and the lowest y bits |
| Mapping and sending of lowest y bits | Comparing an FV with one or more lists including one or more TVs to confirm whether highest x bits of the FV are equal to those of a TV in the list | Sending an index and the lowest y bits | Splicing the lowest y bits by using a value corresponding to an index in a shared table |
| Highest y bits | Directly determining through comparison whether lowest x bits of an FV are equal to those of a TV | Sending the highest y bits | Splicing the TV and the highest y bits |
| Mapping and sending of highest y bits | Comparing an FV with one or more lists including one or more TVs to confirm whether lowest x bits of the FV are equal to those of a TV in the list | Sending an index and the highest y bits | Splicing the highest y bits by using a value corresponding to an index in a shared table |
| Length calculation | Ignore | Blanking | Calculating a length (IP or UDP) |
| Checksum calculation | Ignore | Blanking | Calculating a UDP checksum |
| Device ID | Ignore | Blanking | The device ID is constructed based on an L2 identifier |

In a lossy compression scenario in which precision control is required, a rule operation method of difference calculation may be used, and a configurable compression action, that is, a "not sending" method, is selected within an allowable error range, or an optional compression residual is sent after a compression header.

Optionally, in this application, there is also a secondary deduplication feature of compressed data. The secondary deduplication means that secondary compression can still be performed on data that has been compressed once in a compression process because formats of two data fields in one segment are quite similar. In this application, because a rule is stored in both the compression device and the decompression device, the rule of compressed data does not need to be transmitted. In this case, there is a secondary deduplication feature of compressed data.

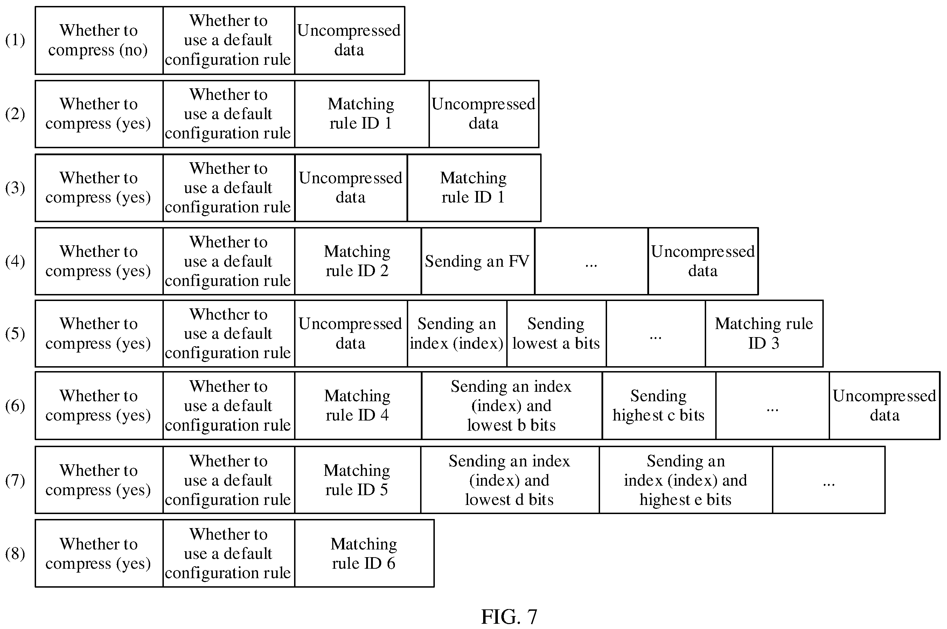

Further, a compressed storage structure that is output after compression is completed may be marked with a mark "whether to compress". In addition, this application further provides a default configuration rule or a default-rule generation method, and a mark "whether to use a default configuration rule" may be added after the mark "whether to compress". The default configuration rule is a configuration rule that can be used by all manufacturers, and may be considered as a common rule. Specifically, a compressed storage structure of compressed data may be shown in FIG. 7.

The compressed storage structure may be an uncompressed structure, for example, (1) in FIG. 7, and is corresponding to a scenario in which no matching rule is matched.

Alternatively, in the compressed storage structure, a matching rule ID (one of the rule 1 to the rule N) may be followed by uncompressed data, for example, (2) in FIG. 7, or a sequence of uncompressed data and a matching rule ID is reversed, for example, (3) in FIG. 7. In this case, the two compressed storage structures are corresponding to a scenario in which a front part of to-be-compressed data fully matches a matching rule ID, a rule operation method for the matching rule does not generate a compression residual, and after matching performed on the matching rule is completed, there is still remaining data to be sent as uncompressed data.

Alternatively, in the compressed storage structure, a matching rule ID may be followed by a compression residual corresponding to a configurable compression action and uncompressed data, for example, (4) and (6) in FIG. 7. A sequence of a matching rule ID, a compression residual, and uncompressed data may be reversed, for example, (5) in FIG. 7. In this case, the three compressed storage structures are corresponding to a scenario in which a front part of to-be-compressed data fully matches a matching rule ID, a rule operation method for the matching rule generates a compression residual, and after matching performed on the matching rule is completed, there is still remaining data to be sent as uncompressed data.

Alternatively, in the compressed storage structure, a matching rule ID may be followed by a compression residual corresponding to a configurable compression action, for example, (7) in FIG. 7, but there is no uncompressed data. In this case, such a compressed storage structure is corresponding to a scenario in which all of to-be-compressed data fully matches a matching rule ID, a rule operation method for the matching rule generates a compression residual, and after matching performed on the rule is completed, there is no remaining data.

Alternatively, in the compressed storage structure, there may be no other data following a matching rule ID, for example, (8) in FIG. 7. In this case, such a compressed storage structure is corresponding to a scenario in which all of to-be-compressed data fully matches a matching rule ID, a rule operation method for the matching rule does not generate a compression residual, and after matching performed on the matching rule is completed, there is no remaining data.

Based on the foregoing implementation, a compression scenario of uplink (UP) transmission is used as an example to describe a compression process. A matching rule configured for the UP transmission scenario may be shown in Table 5. A processing procedure for performing compression processing on to-be-compressed data according to the matching rule shown in Table 5 to obtain compressed data may include the following steps:

**Table 5**

| Protocol | FID | FL | FP | DI | TV | MO | C/DA | #bits-sent |
|---|---|---|---|---|---|---|---|---|
| CoAP | Version | 2 | 1 | Bi | 1 | equal | not-sent | |
| | Type | 2 | 1 | Bi | NON | equal | not-sent | |
| | TKL | 4 | 1 | Bi | 0 | equal | not-sent | |
| | Code | 8 | 1 | Up | {0: POST, 1: GET} | match-mapping | mapping-sent | 1 |
| | | 8 | 1 | Dw | {00: 2.01, 01: 4.00, 10: 5.00, 11: 2.05} | match-mapping | mapping-sent | 2 |
| | MID | 16 | 1 | Bi | 0x0000 | equal | not-sent | |
| | Uri-Path | 8 | 1 | Up | {00: water, 01: gas, 10: electricity, 11: status, 100: config} | match-mapping | mapping-sent | 3 |

Step d1: Process the 1^{st} data field (that is, one piece of to-be-matched data) of the to-be-compressed data, that is, a data field version (Version), where a data bit width of the data field version is 2 bits, and a data value FV is 1. In the 1^{st} rule row of a current matching rule whose rule ID is 0, FID=Version, FL=2, and TV=1. Whether the FV is equal to the TV is directly determined through comparison by using a configurable rule method MO=equal, to obtain a result "True". Therefore, a configurable compression action CDA=not-sent is performed, that is, the FV value is not to be sent.

Step d2: Process the 2^{nd} data field of the to-be-compressed data, that is, a data field type (Type), where a data bit width of the data field type is 2 bits, and a data value FV is NON. In the 2^{nd} rule row of the current matching rule whose rule ID is 0, FID=Type, FL=2, and TV=NON. Whether the FV is equal to the TV is directly determined through comparison by using a configurable rule method MO=equal, to obtain a result "True". Therefore, a configurable compression action CDA=not-sent is performed, that is, the FV value is not to be sent.

Step d3: Process the 3^{rd} data field of the to-be-compressed data, that is, a data field TKL, where a data bit width of the data field TKL is 4 bits, and a data value FV is 0. In the 3^{rd} rule row of the current matching rule whose rule ID is 0, FID=TKL, FL=4, and TV=0. Whether the FV is equal to the TV is directly determined through comparison by using a configurable rule method MO=equal, to obtain a result "True". Therefore, a configurable compression action CDA=not-sent is performed, that is, the FV value is not to be sent.

Step d4: Process the 4^{th} data field of the to-be-compressed data, that is, a data field code (Code), where a data bit width of the data field code is 8 bits, and a data value FV is POST. In a scenario in which the 4^{th} rule row of the current matching rule whose rule ID is 0 is corresponding to uplink (UP), FID=Code, FL=8, and TV={0: POST, 1: GET}. Whether the FV is equal to a TV in the TV list is determined through comparison by using a configurable rule method MO=match-mapping, to obtain a result "True". Therefore, a configurable compression action CDA=mapping-sent is performed, that is, an index value 0 (idx0) of the FV in the TV list is to be sent.

Step d5: Process the 5^{th} data field of the to-be-compressed data, that is, a data field MID, where a data bit width of the data field MID is 16 bits, and a data value FV is 0x0000. In the 5^{th} rule row of the current matching rule whose rule ID is 0, FID=MID, FL=16, and TV=0x0000. Whether the FV is equal to the TV is directly determined through comparison by using a configurable rule method MO=equal, to obtain a result "True". Therefore, a configurable compression action CDA=not-sent is performed, that is, the FV value is not to be sent.

Step d6: Process the 6^{th} data field of the to-be-compressed data, that is, a data field path (Uri-Path), where a data bit width of the data field path is 8 bits, and a data value FV represents "gas" (which is actually character string codes of "gas"). In the 6^{th} rule row of the current matching rule whose rule ID is 0, FID=Uri-Path, and TV={0: water, 1: gas, 2: electricity, 3: status, 4: config}. Whether the FV is equal to a TV in the TV list is determined through comparison by using a configurable rule method MO=match-mapping, to obtain a result "True". Therefore, a configurable compression action CDA=mapping-sent is performed, that is, an index value 1 (idx1) of the FV in the TV list is to be sent.

Step d7: Because the sub-rule whose rule ID is 0 fully matches the to-be-compressed data, a 3-bit compression data header may be added to a foremost part of the compressed data. The 3-bit compression data header successively includes:
a 1-bit mark "whether to compress" whose value is "yes";
a 1-bit "whether to use a default configuration rule" whose value is "no"; and
a 1-bit "matching rule ID" whose value is 0, indicating that a rule ID is 0.

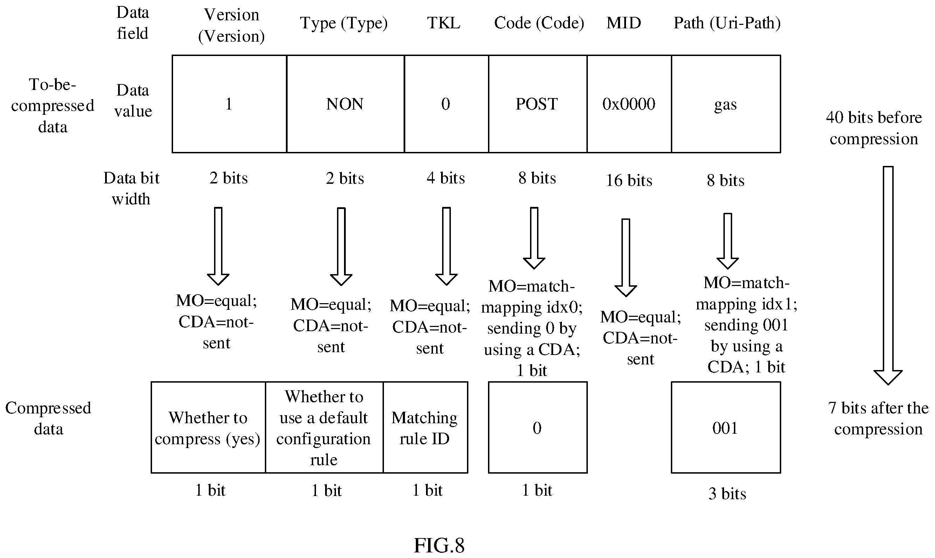

For example, compressed data is obtained after compression processing is performed on to-be-compressed data. This may be shown in FIG. 8.

Based on the foregoing implementation, a decompression scenario of uplink (UP) transmission is used as an example to describe a decompression process. A matching rule configured for the UP transmission scenario may also be shown in Table 5. A processing procedure for performing decompression processing on to-be-decompressed data according to the matching rule shown in Table 5 to obtain decompressed data may include the following steps:
Step e1: Parse the 3-bit data header of the to-be-decompressed data, where the value of the 1-bit mark "whether to compress" is "yes", the value of the 1-bit "whether to use a default configuration rule" is "no", and the value of the 1-bit "rule ID" is 0. Therefore, it is determined that the configurable matching rule whose rule ID is 0 is a decompression rule of the to-be-decompressed data.
Step e2: Process the 1^{st} rule row of the configurable matching rule. Due to the corresponding CDA=not-sent, the values stored in the rule row, that is, FID=Version, FL=2, and TV=1, are used to restore the 1^{st} data field, that is, the data field version, where the data bit width is 2 bits, and the data value FV is 1.
Step e3: Process the 2^{nd} rule row of the configurable matching rule. Due to the corresponding CDA=not-sent, the values stored in the rule row, that is, FID=Type, FL=2, and TV=NON, are used to restore the 2^{nd} data field, that is, the data field type, where the data bit width is 2 bits, and the data value FV is NON.
Step e4: Process the 3^{rd} rule row of the configurable matching rule. Due to the corresponding CDA=not-sent, the values stored in the rule row, that is, FID=TKL, FL=4, and TV=0, are used to restore the 3^{rd} data field, that is, the data field TKL, where the data bit width is 3 bits, and the data value FV is 0.
Step e5: In the scenario in which the 4^{th} rule row of the configurable matching rule is corresponding to the uplink (UP), due to the corresponding CDA=mapping-sent, the value corresponding to the index is obtained from the TV. First, the 1-bit index value 0 (idx0) is extracted from the to-be-decompressed data and POST is obtained from TV={0: POST, 1: GET}, and then FID=Code and FL=8 are used to restore the 4^{th} data field, that is, the data field code, where the data bit width is 8 bits, and the data value FV is POST.
Step e6: Process the 5^{th} rule row of the configurable matching rule. Due to the corresponding CDA=not-sent, the values stored in the rule row, that is, FID=MID, FL=16, and TV=0x0000, are used to restore the 5^{th} data field, that is, the data field MID, where the data bit width is 16 bits, and the data value FV is 0x0000.
Step e7: In the scenario in which the 6^{th} rule row of the configurable matching rule is corresponding to the uplink (UP), due to the corresponding CDA=mapping-sent, the value corresponding to the index is obtained from the TV First, the 3-bit index value 1 (idx1) is extracted from the to-be-decompressed data and "gas" is obtained from TV={0: water, 1: gas, 2: electricity, 3: status, 4: config}, and then FID=Uri-Path is used to restore the 6^{th} data field, that is, the data field Uri-Path, where the data value FV represents character string codes corresponding to a character string "gas".

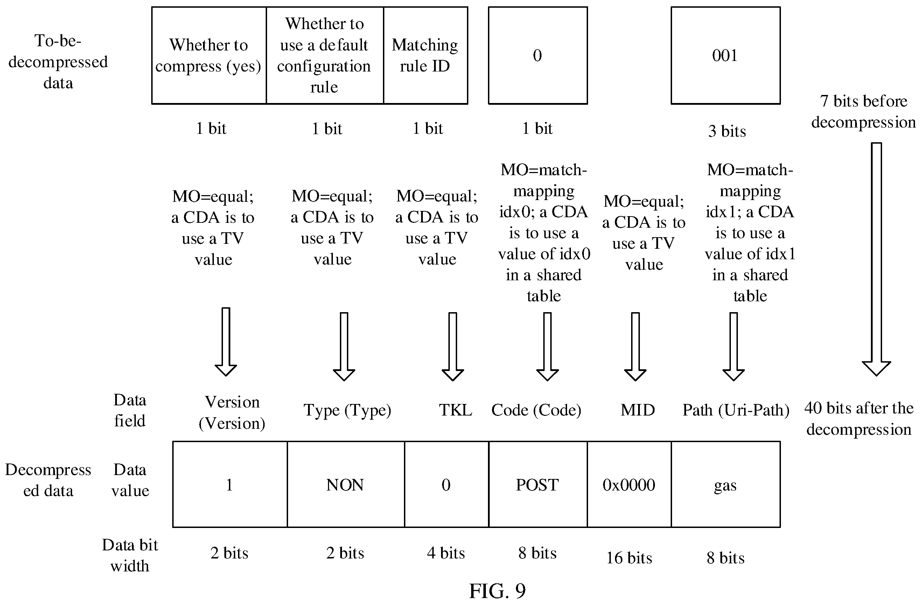

For example, decompressed data is obtained after decompression processing is performed on to-be-compressed data. This may be shown in FIG. 9.

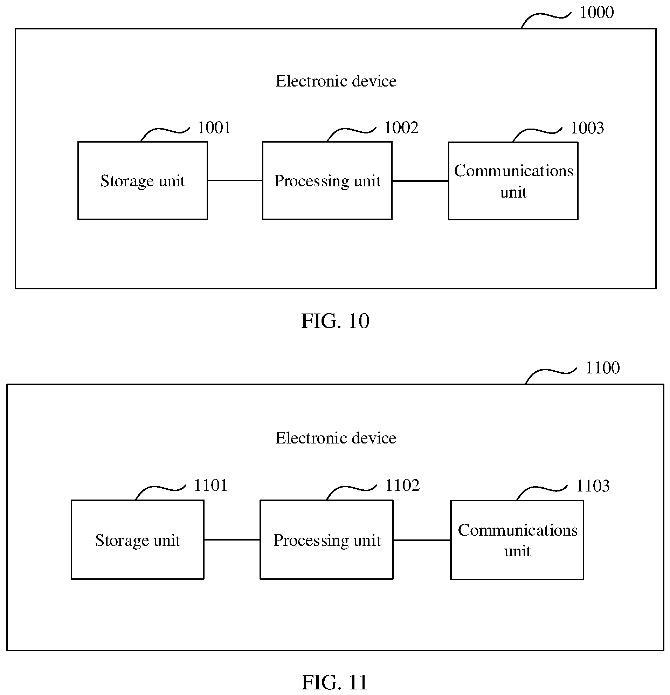

Based on the foregoing implementation, an implementation of this application further provides an electronic device. The electronic device is applied to the system shown in FIG. 1, and is configured to implement the data compression method shown in FIG. 2. Refer to FIG. 10. The electronic device 1000 includes a storage unit 1001, a processing unit 1002, and a communications unit 1003.

The storage unit 1001 is configured to store one or more matching rules. Each matching rule includes one or more matching entries, each matching entry is used to perform matching on to-be-matched data in a to-be-matched data group, the to-be-matched data group includes one or more pieces of to-be-matched data, and each piece of to-be-matched data includes one or more bits of data. Each matching entry includes: a preset field; a matching rule field, used to indicate to perform matching between first data in to-be-matched data and the preset field according to a specific rule; and a compression rule field, used to indicate, based on a matching result that is obtained through matching by using the matching rule field, that data is not to be sent or that one or more bits are to be sent. When one or more bits are indicated to be sent, the one or more bits are one or more bits corresponding to the preset field.

The communications unit 1003 is configured to receive a to-be-matched data group.

The processing unit 1002 is configured to: obtain a target matching rule by performing matching based on the preset field and the matching rule field in each matching entry in the one or more matching rules, and perform processing based on a compression rule field in each matching entry in the target matching rule.

In an implementation, the one or more bits corresponding to the preset field include: one or more bits that are included in the preset field and that are corresponding to the first data; or one or more bits corresponding to the matching result that is obtained in a specific calculation manner corresponding to the preset field.

For example, the one or more bits corresponding to the preset field are bits representing a minimum quantity of bits of the first data.

In an optional implementation, the compression rule field indicates that data is not to be sent, and the matching result is that the first data is equal to the preset field; or the compression rule field indicates that one or more bits are to be sent, and the matching result is one of the following: the first data is equal to one of a plurality of pieces of preset data in the preset field, a part of the first data is equal to the preset field, and the first data and the preset field conform to the specific calculation manner.

Specifically, each matching entry further includes one or more data feature fields, and each data feature field is used to indicate a data feature of the first data in the to-be-matched data.

In an optional implementation, a compressed data group obtained after the processing unit 1002 performs compression processing based on a preset field, a matching rule field, and the compression rule field in each matching entry in the target matching rule includes an indication indicating whether to perform compression and an identifier of the target matching rule.

In an example implementation, each matching entry further includes a decompression rule field, used to indicate, based on the matching result that is obtained through matching by using the matching rule field, to restore the preset field or to restore original data corresponding to second data. The second data is any piece of to-be-decompressed data in a to-be-decompressed data group, and the second data is the one or more bits corresponding to the preset field. The communications unit 1003 is further configured to receive a to-be-decompressed data group; and the processing unit 1002 is further configured to: determine the target matching rule from the one or more matching rules, and perform processing based on the preset field, the matching rule field, and a decompression rule field in each matching entry in the target matching rule.

For example, when determining the target matching rule from the one or more matching rules, the processing unit 1002 is specifically configured to determine the target matching rule from the one or more matching rules based on the identifier of the target matching rule in the to-be-decompressed data group.

In an optional implementation, the electronic device includes one or more interfaces, configured to receive one or more new matching rules; and the one or more new matching rules are configured based on a new service.

Based on the foregoing implementation, an implementation of this application further provides an electronic device. The electronic device is applied to the system shown in FIG. 1, and is configured to implement the data decompression method shown in FIG. 4. Refer to FIG. 11. The electronic device 1100 includes a storage unit 1101, a processing unit 1102, and a communications unit 1103.

The storage unit 1101 is configured to store one or more matching rules. Each matching rule includes one or more matching entries, and each matching entry is used to perform matching on to-be-decompressed data in a to-be-decompressed data group. Each matching entry includes: a preset field; a matching rule field, used to indicate to perform matching between first data in original data and the preset field according to a specific rule; and a decompression rule field, used to indicate, based on a matching result that is obtained through matching by using the matching rule field, to restore the preset field or to restore the original data corresponding to second data. The second data is any piece of to-be-decompressed data in the to-be-decompressed data group, and the second data is one or more bits corresponding to the preset field.

The communications unit 1103 is configured to receive a to-be-decompressed data group.

The processing unit 1102 is configured to: determine a target matching rule from the one or more matching rules, and perform processing based on a preset field, a matching rule field, and a decompression rule field in each matching entry in the target matching rule.

In an implementation, the one or more bits corresponding to the preset field include: one or more bits that are included in the preset field and that are corresponding to the first data; or one or more bits corresponding to the matching result that is obtained in a specific calculation manner corresponding to the preset field.

For example, the one or more bits corresponding to the preset field are bits representing a minimum quantity of bits of the first data.

Specifically, the to-be-decompressed data includes an indication indicating whether to perform compression and an identifier of the target matching rule; and when determining the target matching rule from the one or more matching rules, the processing unit 1102 is specifically configured to determine the target matching rule from the one or more matching rules based on the identifier of the target matching rule in the to-be-decompressed data group.

During specific implementation, each matching entry further includes one or more data feature fields, and each data feature field is used to indicate a data feature of the first data.

In an optional implementation, each matching entry further includes a compression rule field, used to indicate, based on the matching result that is obtained through matching by using the matching rule field, that data is not to be sent or that one or more bits are to be sent. When one or more bits are indicated to be sent, the one or more bits are the one or more bits corresponding to the preset field. The communications unit 1103 is further configured to receive a to-be-matched data group; and the processing unit 1102 is further configured to: obtain the target matching rule by performing matching based on the preset field and the matching rule field in each matching entry in the one or more matching rules, and perform processing based on a compression rule field in each matching entry in the target matching rule. The to-be-matched data group includes one or more pieces of to-be-matched data, each piece of to-be-matched data includes one or more bits of data, and the to-be-matched data includes the first data.

For example, the compression rule field indicates that data is not to be sent, and the matching result is that the first data is equal to the preset field; or the compression rule field indicates that one or more bits are to be sent, and the matching result is one of the following: the first data is equal to one of a plurality of pieces of preset data in the preset field, a part of the first data is equal to the preset field, and the first data and the preset field conform to the specific calculation manner.

In an optional implementation, the electronic device includes one or more interfaces, configured to receive one or more new matching rules; and the one or more new matching rules are configured based on a new service.

It should be noted that, in the implementations of this application, division into the units is an example, and is merely a logical function division. In an actual implementation, another division manner may be used. Functional units in the implementations of this application may be integrated into one processing unit, or each of the units may exist alone physically, or two or more units may be integrated into one unit. The integrated unit may be implemented in a form of hardware, or may be implemented in a form of a software functional unit.

When the integrated unit is implemented in a form of a software functional unit and sold or used as an independent product, the integrated unit may be stored in a computer-readable storage medium. Based on such an understanding, the technical solutions of this application essentially, or the part contributing to the conventional technology, or all or some of the technical solutions may be implemented in a form of a software product. The computer software product is stored in a storage medium and includes several instructions for instructing a computer device (which may be a personal computer, a server, a network device, or the like) or a processor (processor) to perform all or some of the steps of the method in the implementations of this application. The foregoing storage medium includes: any medium that can store program code, such as a USB flash drive, a removable hard disk drive, a read-only memory (read-only memory, ROM), a random access memory (random access memory, RAM), a magnetic disk, or an optical disc.

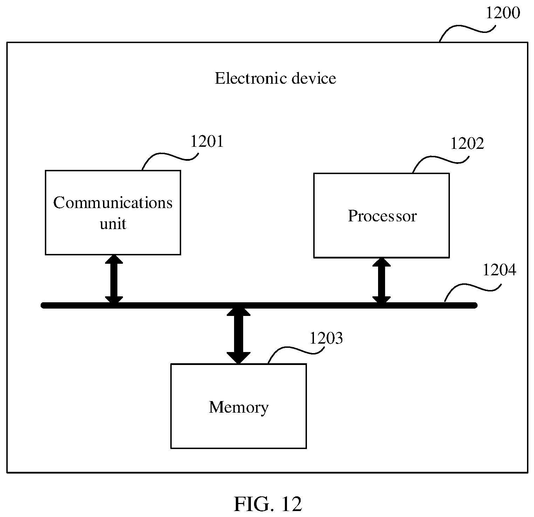

Based on the foregoing implementation, an implementation of this application further provides an electronic device. The electronic device is configured to implement the data compression method shown in FIG. 2. Refer to FIG. 12. The electronic device 1200 includes a communications unit 1201, a processor 1202, and a memory 1203.

The processor 1202 may be a central processing unit (central processing unit, CPU), a network processor (network processor, NP), or a combination of the CPU and the NP. The processor 1102 may further include a hardware chip. The hardware chip may be an application-specific integrated circuit (application-specific integrated circuit, ASIC), a programmable logic device (programmable logic device, PLD), or a combination thereof. The PLD may be a complex programmable logic device (complex programmable logic device, CPLD), a field programmable logic gate array (field programmable gate array, FPGA), a generic array logic (generic array logic, GAL), or any combination thereof.

The communications unit 1201, the processor 1202, and the memory 1203 are connected to each other. Optionally, the communications unit 1201, the processor 1202, and the memory 1203 are connected to each other by using a bus 1204. The bus 1204 may be a peripheral component interconnect (Peripheral Component Interconnect, PCI) bus, an extended industry standard architecture (Extended Industry Standard Architecture, EISA) bus, or the like. The bus may be classified into an address bus, a data bus, a control bus, and the like. For ease of representation, only one thick line is used to represent the bus in FIG. 12, but this does not mean that there is only one bus or only one type of bus.

When the electronic device 1200 implements the data compression method shown in FIG. 2,
the memory 1203 is configured to store one or more matching rules, where each matching rule includes one or more matching entries, each matching entry is used to perform matching on to-be-matched data in a to-be-matched data group, the to-be-matched data group includes one or more pieces of to-be-matched data, each piece of to-be-matched data includes one or more bits of data, and each matching entry includes: a preset field; a matching rule field, used to indicate to perform matching between first data in to-be-matched data and the preset field according to a specific rule; and a compression rule field, used to indicate, based on a matching result that is obtained through matching by using the matching rule field, that data is not to be sent or that one or more bits are to be sent, where when one or more bits are indicated to be sent, the one or more bits are one or more bits corresponding to the preset field;
the communications unit 1201 is configured to receive a to-be-matched data group; and
the processor 1202 is configured to: obtain a target matching rule by performing matching based on the preset field and the matching rule field in each matching entry in the one or more matching rules, and perform processing based on a compression rule field in each matching entry in the target matching rule.

In an implementation, the one or more bits corresponding to the preset field include: one or more bits that are included in the preset field and that are corresponding to the first data; or one or more bits corresponding to the matching result that is obtained in a specific calculation manner corresponding to the preset field.

For example, the one or more bits corresponding to the preset field are bits representing a minimum quantity of bits of the first data.

In an optional implementation, the compression rule field indicates that data is not to be sent, and the matching result is that the first data is equal to the preset field; or the compression rule field indicates that one or more bits are to be sent, and the matching result is one of the following: the first data is equal to one of a plurality of pieces of preset data in the preset field, a part of the first data is equal to the preset field, and the first data and the preset field conform to the specific calculation manner.

Specifically, each matching entry further includes one or more data feature fields, and each data feature field is used to indicate a data feature of the first data in the to-be-matched data.

In an optional implementation, a compressed data group obtained after the processor 1202 performs compression processing based on a preset field, a matching rule field, and the compression rule field in each matching entry in the target matching rule includes an indication indicating whether to perform compression and an identifier of the target matching rule.

In an example implementation, each matching entry further includes a decompression rule field, used to indicate, based on the matching result that is obtained through matching by using the matching rule field, to restore the preset field or to restore original data corresponding to second data. The second data is any piece of to-be-decompressed data in a to-be-decompressed data group, and the second data is the one or more bits corresponding to the preset field. The communications unit 1201 is further configured to receive a to-be-decompressed data group, and the processor 1202 is further configured to: determine the target matching rule from the one or more matching rules, and perform processing based on the preset field, the matching rule field, and a decompression rule field in each matching entry in the target matching rule.

For example, when determining the target matching rule from the one or more matching rules, the processor 1202 is specifically configured to determine the target matching rule from the one or more matching rules based on the identifier of the target matching rule in the to-be-decompressed data group.

In an optional implementation, the electronic device 1200 includes one or more interfaces, configured to receive one or more new matching rules; and the one or more new matching rules are configured based on a new service.

In an optional implementation, the memory 1203 is configured to store a program and the like. Specifically, the program may include program code, and the program code includes computer operation instructions. The memory 1203 may include a RAM, and may further include a nonvolatile memory (non-volatile memory), for example, at least one magnetic disk storage. The processor 1202 executes an application program stored in the memory 1203, to implement the foregoing function, thereby implementing the data compression method shown in FIG. 2.

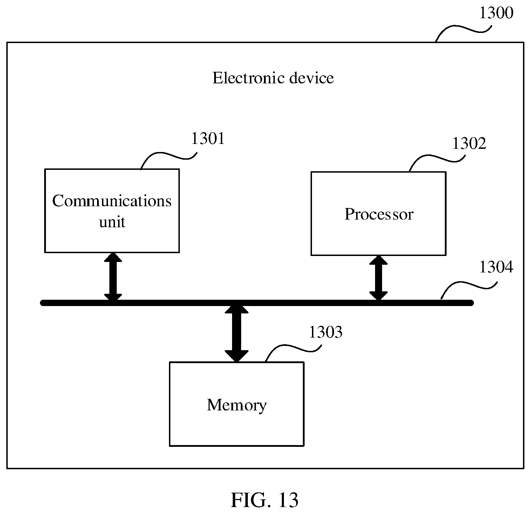

Based on the foregoing implementation, an implementation of this application further provides an electronic device. The electronic device is configured to implement the data decompression method shown in FIG. 4. Refer to FIG. 13. The electronic device 1300 includes a communications unit 1301, a processor 1302, and a memory 1303.

The processor 1302 may be a central processing unit (central processing unit, CPU), a network processor (network processor, NP), or a combination of a CPU and an NP. The processor 1302 may further include a hardware chip. The hardware chip may be an application-specific integrated circuit (application-specific integrated circuit, ASIC), a programmable logic device (programmable logic device, PLD), or a combination thereof. The PLD may be a complex programmable logic device (complex programmable logic device, CPLD), a field programmable logic gate array (field programmable gate array, FPGA), a generic array logic (generic array logic, GAL), or any combination thereof.

The communications unit 1301, the processor 1302, and the memory 1303 are connected to each other. Optionally, the communications unit 1301, the processor 1302, and the memory 1303 are connected to each other by using a bus 1304. The bus 1304 may be a peripheral component interconnect (Peripheral Component Interconnect, PCI) bus, an extended industry standard architecture (Extended Industry Standard Architecture, EISA) bus, or the like. The bus may be classified into an address bus, a data bus, a control bus, and the like. For ease of representation, only one thick line is used to represent the bus in FIG. 13, but this does not mean that there is only one bus or only one type of bus.

When the second device 1300 implements the data decompression method shown in FIG. 4,
the memory 1303 is configured to store one or more matching rules, where each matching rule includes one or more matching entries, each matching entry is used to perform matching on to-be-decompressed data in a to-be-decompressed data group, and each matching entry includes: a preset field; a matching rule field, used to indicate to perform matching between first data in original data and the preset field according to a specific rule; and a decompression rule field, used to indicate, based on a matching result that is obtained through matching by using the matching rule field, to restore the preset field or to restore the original data corresponding to second data, where the second data is any piece of to-be-decompressed data in the to-be-decompressed data group, and the second data is one or more bits corresponding to the preset field;
the communications unit 1301 is configured to receive a to-be-decompressed data group; and
the processor 1302 is configured to: determine a target matching rule from the one or more matching rules, and perform processing based on a preset field, a matching rule field, and a decompression rule field in each matching entry in the target matching rule.

In an implementation, the one or more bits corresponding to the preset field include: one or more bits that are included in the preset field and that are corresponding to the first data; or one or more bits corresponding to the matching result that is obtained in a specific calculation manner corresponding to the preset field.

For example, the one or more bits corresponding to the preset field are bits representing a minimum quantity of bits of the first data.

Specifically, the to-be-decompressed data includes an indication indicating whether to perform compression and an identifier of the target matching rule; and when determining the target matching rule from the one or more matching rules, the processor 1302 is specifically configured to determine the target matching rule from the one or more matching rules based on the identifier of the target matching rule in the to-be-decompressed data group.

During specific implementation, each matching entry further includes one or more data feature fields, and each data feature field is used to indicate a data feature of the first data.

In an optional implementation, each matching entry further includes a compression rule field, used to indicate, based on the matching result that is obtained through matching by using the matching rule field, that data is not to be sent or that one or more bits are to be sent. When one or more bits are indicated to be sent, the one or more bits are the one or more bits corresponding to the preset field. The communications unit 1301 is further configured to receive a to-be-matched data group; and the processor 1302 is further configured to: obtain the target matching rule by performing matching based on the preset field and the matching rule field in each matching entry in the one or more matching rules, and perform processing based on a compression rule field in each matching entry in the target matching rule. The to-be-matched data group includes one or more pieces of to-be-matched data, each piece of to-be-matched data includes one or more bits of data, and the to-be-matched data includes the first data.

For example, the compression rule field indicates that data is not to be sent, and the matching result is that the first data is equal to the preset field; or the compression rule field indicates that one or more bits are to be sent, and the matching result is one of the following: the first data is equal to one of a plurality of pieces of preset data in the preset field, a part of the first data is equal to the preset field, and the first data and the preset field conform to the specific calculation manner.

In an optional implementation, the electronic device includes one or more interfaces, configured to receive one or more new matching rules; and the one or more new matching rules are configured based on a new service.

In an optional implementation, the memory 1303 is configured to store a program and the like. Specifically, the program may include program code, and the program code includes computer operation instructions. The memory 1303 may include a RAM, and may further include a non-volatile memory (non-volatile memory), for example, at least one magnetic disk storage. The processor 1202 executes an application program stored in the memory 1303, to implement the foregoing function, thereby implementing the data decompression method shown in FIG. 4.

A person skilled in the art should understand that the implementations of this application may be provided as a method, a system, or a computer program product. Therefore, this application may use a form of hardware only implementations, software only implementations, or implementations with a combination of software and hardware. In addition, this application may use a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the device (system), and the computer program product according to the implementations of this application. It should be understood that computer program instructions may be used to implement each procedure and/or each block in the flowcharts and/or the block diagrams and a combination of a procedure and/or a block in the flowcharts and/or the block diagrams. These computer program instructions may be provided for a general-purpose computer, a dedicated computer, an embedded processor, or a processor of another programmable data processing device to generate a machine, so that the instructions executed by the computer or the processor of the another programmable data processing device generate an apparatus for implementing a specific function in one or more procedures in the flowcharts and/or in one or more blocks in the block diagrams.

These computer program instructions may alternatively be stored in a computer-readable memory that can indicate a computer or another programmable data processing device to work in a specific manner, so that the instructions stored in the computer-readable memory generate an artifact that includes an instruction apparatus. The instruction apparatus implements a specific function in one or more procedures in the flowcharts and/or in one or more blocks in the block diagrams.

These computer program instructions may alternatively be loaded onto the computer or the another programmable data processing device, so that a series of operations and steps are performed on the computer or the another programmable device, to generate computer-implemented processing. Therefore, the instructions executed on the computer or the another programmable device provide steps for implementing a specific function in one or more procedures in the flowcharts and/or in one or more blocks in the block diagrams.

The scope of protection shall be defined by the appended claims.

## Claims

1. A data compression method for use in an electronic device for sending compressed data, wherein the electronic device comprises a processor and a memory, the memory stores one or more matching rules, each matching rule comprises one or more matching entries, each matching entry is used to perform matching on to-be-matched data in a to-be-matched data group, the to-be-matched data group comprises one or more pieces of to-be-matched data, and each piece of to-be-matched data comprises one or more bits of data;
each matching entry comprises: a preset field; a matching rule field, used to indicate to perform matching between first data in to-be-matched data and the preset field according to a specific rule; and a compression rule field, used to indicate, based on a matching result that is obtained through matching by using the matching rule field, that data is not to be sent or that one or more bits are to be sent, wherein when one or more bits are indicated to be sent, the one or more bits are one or more bits corresponding to the preset field;
wherein the preset field comprises a target value, TV;
wherein the matching rule field comprises a matching operator, MO, configured to define a matching manner between a field value, FV, of the to-be-matched data and the TV, and an operation result is True or False;
wherein the compression rule field comprises a compression action to be performed when an operation result of an associated matching operator returns True;
wherein the matching operator of a first matching entry comprises an equal operator in which the operation result is True if the FV is equal to the TV, and the compression action comprises not sending the data;
wherein the matching operator of a second matching entry comprises an ignore operator in which the operation result is always True, and the compression action comprises sending the data;
wherein the matching operator of a third matching entry comprises a comparison of highest x bits operator in which the operation result is True if the highest x bits of the FV is equal to those of a TV in a rule, wherein the parameter x is a compared length, and the compression action comprises sending the lowest y bits of the data; and
wherein the matching operator of a fourth matching entry comprises a matching mapping operator in which the TV comprises a list of values, where each value in the list of values is identified by a short ID, and the operation result is True if the FV is equal to one of the values in the target value list, and the compression action comprises sending an index value of the FV in the list of values; and
the method comprises:
receiving (201) a to-be-matched data group,
obtaining (202) a target matching rule by performing matching based on the preset field and the matching rule field in each matching entry in the one or more matching rules, and
performing (203) processing based on a compression rule field in each matching entry in the target matching rule;
wherein a compressed data group obtained after compression processing is performed based on a preset field, a matching rule field, and the compression rule field in each matching entry in the target matching rule comprises an indication indicating whether to perform compression and an identifier of the target matching rule.

2. The method according to claim 1, wherein the one or more bits corresponding to the preset field comprise:
one or more bits that are comprised in the preset field and that are corresponding to the first data; or
one or more bits corresponding to the matching result that is obtained in a specific calculation manner corresponding to the preset field.

3. The method according to claim 1 or 2, wherein the one or more bits corresponding to the preset field are bits representing a minimum quantity of bits of the first data.

4. The method according to any one of claims 1 to 3, wherein
the compression rule field indicates that data is not to be sent, and the matching result is that the first data is equal to the preset field; or
the compression rule field indicates that one or more bits are to be sent, and the matching result is one of the following: the first data is equal to one of a plurality of pieces of preset data in the preset field, a part of the first data is equal to the preset field, and the first data and the preset field conform to the specific calculation manner.

5. The method according to any one of claims 1 to 4, wherein each matching entry further comprises one or more data feature fields, and each data feature field is used to indicate a data feature of the first data in the to-be-matched data.

6. The method according to any one of claims 1 to 5, wherein each matching entry further comprises a decompression rule field, used to indicate, based on the matching result that is obtained through matching by using the matching rule field, to restore the preset field or to restore original data corresponding to second data, wherein the second data is any piece of to-be-decompressed data in a to-be-decompressed data group, and the second data is the one or more bits corresponding to the preset field; and
the method further comprises:
receiving a to-be-decompressed data group, determining the target matching rule from the one or more matching rules, and performing processing based on the preset field, the matching rule field, and a decompression rule field in each matching entry in the target matching rule.

7. The method according to claim 6, wherein the determining the target matching rule from the one or more matching rules comprises:
determining the target matching rule from the one or more matching rules based on the identifier of the target matching rule in the to-be-decompressed data group.

8. A data decompression method for use in an electronic device for receiving compressed data, wherein the electronic device comprises a processor and a memory, the memory stores one or more matching rules, each matching rule comprises one or more matching entries, and each matching entry is used to perform matching on to-be-decompressed data in a to-be-decompressed data group;
each matching entry comprises: a preset field; a matching rule field, used to indicate to perform matching between first data in original data and the preset field according to a specific rule; and a decompression rule field, used to indicate, based on a matching result that is obtained through matching by using the matching rule field, to restore the preset field or to restore the original data corresponding to second data, wherein the second data is any piece of to-be-decompressed data in the to-be-decompressed data group, and the second data is one or more bits corresponding to the preset field; and
the method comprises:
receiving (401) a to-be-decompressed data group,
determining (402) a target matching rule from the one or more matching rules, and
performing (403) processing based on a preset field, a matching rule field, and a decompression rule field in each matching entry in the target matching rule;
wherein the to-be-decompressed data comprises an indication indicating whether to perform compression and an identifier of the target matching rule; and
the determining a target matching rule from the one or more matching rules comprises:
determining the target matching rule from the one or more matching rules based on the identifier of the target matching rule in the to-be-decompressed data group;
wherein the preset field comprises a target value, TV;
the decompression rule field comprises a decompression action to be performed;
the decompression action of a first matching entry comprises using a value stored in the TV of the first matching entry;
the decompression action of a second matching entry comprises using a received value;
the decompression action of a third matching entry comprises splicing the TV of the third matching entry and the lowest y bits of the compressed data; and
the decompression action of a fourth matching entry comprises using a value corresponding to an index in a shared table.

9. The method according to claim 8, wherein the one or more bits corresponding to the preset field comprise:
one or more bits that are comprised in the preset field and that are corresponding to the first data; or
one or more bits corresponding to the matching result that is obtained in a specific calculation manner corresponding to the preset field.

10. The method according to claim 8 or 9, wherein the one or more bits corresponding to the preset field are bits representing a minimum quantity of bits of the first data.

11. The method according to any one of claims 8 to 10, wherein each matching entry further comprises one or more data feature fields, and each data feature field is used to indicate a data feature of the first data.

12. The method according to any one of claims 8 to 11, wherein each matching entry further comprises a compression rule field, used to indicate, based on the matching result that is obtained through matching by using the matching rule field, that data is not to be sent or that one or more bits are to be sent, wherein when one or more bits are indicated to be sent, the one or more bits are the one or more bits corresponding to the preset field; and
the method further comprises:
receiving a to-be-matched data group, obtaining the target matching rule by performing matching based on the preset field and the matching rule field in each matching entry in the one or more matching rules, and performing processing based on the compression rule field in each matching entry in the target matching rule, wherein the to-be-matched data group comprises one or more pieces of to-be-matched data, each piece of to-be-matched data comprises one or more bits of data, and the to-be-matched data comprises the first data.

13. The method according to claim 12, wherein
the compression rule field indicates that data is not to be sent, and the matching result is that the first data is equal to the preset field; or
the compression rule field indicates that one or more bits are to be sent, and the matching result is one of the following: the first data is equal to one of a plurality of pieces of preset data in the preset field, a part of the first data is equal to the preset field, and the first data and the preset field conform to the specific calculation manner.

14. The method according to any one of claims 1 to 13, wherein the electronic device comprises one or more interfaces, configured to receive one or more new matching rules; and the one or more new matching rules are configured based on a new service.

15. An electronic device, wherein the electronic device comprises a processor, a memory, and a communications unit; wherein the communications unit is configured to receive/send data; and the memory comprising a set of instructions, which when executed by the processor cause the electronic device to perform the method according to any one of claims 1 to 14.

## Patentansprüche

1. Datenkomprimierungsverfahren zum Verwenden in einer elektronischen Vorrichtung zum Senden von komprimierten Daten, wobei die elektronische Vorrichtung einen Prozessor und einen Speicher umfasst, der Speicher eine oder mehrere Abgleichsregeln speichert, jede Abgleichsregel einen oder mehrere Abgleichseinträge umfasst, jeder Abgleichseintrag verwendet wird, um einen Abgleich an abzugleichenden Daten in einer abzugleichenden Datengruppe durchzuführen, die abzugleichende Datengruppe ein oder mehrere Teile von abzugleichenden Daten umfasst und jeder Teil von abzugleichenden Daten ein oder mehrere Datenbits umfasst;
wobei jeder Abgleicheintrag Folgendes umfasst: ein voreingestelltes Feld; ein Abgleichsregelfeld, das verwendet wird, um anzugeben, dass ein Abgleich zwischen ersten Daten in abzugleichenden Daten und dem voreingestellten Feld gemäß einer spezifischen Regel durchzuführen ist; und ein Komprimierungsregelfeld, das verwendet wird, um basierend auf einem Abgleichsergebnis, das durch den Abgleich unter Verwendung des Abgleichsregelfeldes erlangt wird, anzugeben, dass Daten nicht zu senden sind oder dass ein oder mehrere Bits zu senden sind, wobei, wenn angegeben wird, dass ein oder mehrere Bits zu senden sind, das eine oder die mehreren Bits ein oder mehrere Bits sind, die dem voreingestellten Feld entsprechen;
wobei das voreingestellte Feld einen Zielwert (TV) umfasst;
wobei das Abgleichsregelfeld einen Abgleichsoperator (MO) umfasst, der dazu konfiguriert ist, eine Abgleichsart zwischen einem Feldwert (FV) der abzugleichenden Daten und dem TV zu definieren, und ein Operationsergebnis wahr oder falsch ist;
wobei das Abgleichsregelfeld eine Komprimierungsaktion umfasst, die durchzuführen ist, wenn ein Operationsergebnis eines zugeordneten Abgleichsoperators "wahr" zurückgibt;
wobei der Abgleichsoperator eines ersten Abgleichseintrags einen Gleichheitsoperator umfasst, bei dem das Operationsergebnis "wahr" ist, wenn der FV gleich dem TV ist, und die Komprimierungsaktion das Nichtversenden der Daten umfasst;
wobei der Abgleichsoperator eines zweiten Abgleichseintrags einen Ignorieroperator umfasst, bei dem das Operationsergebnis immer "wahr" ist, und die Komprimierungsaktion Senden der Daten umfasst;
wobei der Abgleichsoperator eines dritten Abgleichseintrags einen Operator für den Vergleich der höchsten x Bits umfasst, bei dem das Operationsergebnis "wahr" ist, wenn die höchsten x Bits des FV gleich denen eines TV in einer Regel sind, wobei der Parameter x eine verglichene Länge ist, und die Komprimierungsaktion das Senden der niedrigsten y Bits der Daten umfasst; und
wobei der Abgleichsoperator eines vierten Abgleichseintrags einen Abgleichsabbildungsoperator umfasst, bei dem der TV eine Liste von Werten umfasst, wobei jeder Wert in der Liste von Werten durch eine kurze ID identifiziert wird, und das Operationsergebnis "wahr" ist, wenn der FV gleich einem der Werte in der Zielwertliste ist, und die Komprimierungsaktion das Senden eines Indexwerts des FV in der Liste von Werten umfasst; und
wobei das Verfahren Folgendes umfasst:
Empfangen (201) einer abzugleichenden Datengruppe,
Erlangen (202) einer Zielabgleichsregel durch Durchführen eines Abgleichs basierend auf dem voreingestellten Feld und dem Abgleichsregelfeld in jedem Abgleichseintrag in der einen oder mehreren Abgleichsregeln, und
Durchführen (203) von Verarbeiten basierend auf einem Komprimierungsregelfeld in jedem Abgleichseintrag in der Zielabgleichsregel;
wobei eine komprimierte Datengruppe, die nach Durchführen einer Komprimierungsverarbeitung auf Grundlage eines voreingestellten Feldes, eines Abgleichsregelfeldes und eines Komprimierungsregelfeldes in jedem Abgleichseintrag in der Zielabgleichsregel erlangt wird, eine Angabe, ob eine Komprimierung durchzuführen ist, und eine Kennung der Zielabgleichsregel umfasst.

2. Verfahren nach Anspruch 1, wobei das eine oder die mehreren Bits, die dem voreingestellten Feld entsprechen, Folgendes umfassen:
ein oder mehrere Bits, die in dem voreingestellten Feld enthalten sind und die den ersten Daten entsprechen; oder
ein oder mehrere Bits, die dem Abgleichsergebnis entsprechen, das auf eine bestimmte, dem voreingestellten Feld entsprechende Berechnungsart erlangt wird.

3. Verfahren nach Anspruch 1 oder 2, wobei das eine oder die mehreren Bits, die dem voreingestellten Feld entsprechen, Bits sind, die eine Mindestmenge an Bits der ersten Daten darstellen.

4. Verfahren nach einem der Ansprüche 1 bis 3, wobei
das Komprimierungsregelfeld angibt, dass keine Daten zu senden sind, und das Abgleichsregelfeld ergibt, dass die ersten Daten gleich dem voreingestellten Feld sind; oder
das Komprimierungsregelfeld angibt, dass ein oder mehrere Bits zu senden sind, und das Abgleichsergebnis eines von Folgendem ist: die ersten Daten sind gleich einem von einer Vielzahl von voreingestellten Daten im voreingestellten Feld, ein Teil der ersten Daten ist gleich dem voreingestellten Feld und die ersten Daten und das voreingestellte Feld stimmen mit der spezifischen Berechnungsart überein.

5. Verfahren nach einem der Ansprüche 1 bis 4, wobei jeder Abgleichseintrag ferner ein oder mehrere Datenmerkmalsfelder umfasst und jedes Datenmerkmalsfeld verwendet wird, um ein Datenmerkmal der ersten Daten in den abzugleichenden Daten anzugeben.

6. Verfahren nach einem der Ansprüche 1 bis 5, wobei jeder Abgleichseintrag ferner ein Dekomprimierungsregelfeld umfasst, das verwendet wird, um basierend auf dem Abgleichsergebnis, das durch den Abgleich unter Verwendung des Abgleichsregelfeldes erlangt wird, anzugeben, dass das voreingestellte Feld wiederherzustellen ist oder dass die ursprünglichen Daten, die den zweiten Daten entsprechen, wiederherzustellen sind, wobei die zweiten Daten ein beliebiger Teil von zu dekomprimierenden Daten in einer zu dekomprimierenden Datengruppe sind und die zweiten Daten das eine oder die mehreren Bits sind, die dem voreingestellten Feld entsprechen; und
wobei das Verfahren ferner Folgendes umfasst:
Empfangen einer zu dekomprimierenden Datengruppe, Bestimmen der Zielabgleichsregel aus der einen oder den mehreren Abgleichsregeln und Durchführen einer Verarbeitung basierend auf dem voreingestellten Feld, dem Abgleichsregelfeld und einem Dekomprimierungsregelfeld in jedem Abgleichseintrag in der Zielabgleichsregel.

7. Verfahren nach Anspruch 6, wobei das Bestimmen der Zielabgleichsregeln aus der einen oder den mehreren Abgleichsregeln Folgendes umfasst:
Bestimmen der Zielabgleichsregel aus der einen oder den mehreren Abgleichsregeln basierend auf der Kennung der Zielabgleichsregel in der zu dekomprimierenden Datengruppe.

8. Datendekomprimierungsverfahren zum Verwenden in einer elektronischen Vorrichtung zum Empfangen von komprimierten Daten, wobei die elektronische Vorrichtung einen Prozessor und einen Speicher umfasst, der Speicher eine oder mehrere Abgleichsregeln speichert, jede Abgleichsregel einen oder mehrere Abgleichseinträge umfasst, und jeder Abgleichseintrag verwendet wird, um einen Abgleich mit zu dekomprimierenden Daten in einer zu dekomprimierenden Datengruppe durchzuführen;
jeder Abgleichseintrag Folgendes umfasst: ein Abgleichsregelfeld; ein Abgleichsregelfeld, das verwendet wird, um anzugeben, dass ein Abgleich zwischen ersten Daten in Originaldaten und dem Abgleichsregelfeld gemäß einer spezifischen Regel durchzuführen ist; und ein Dekomprimierungsregelfeld, das verwendet wird, um basierend auf einem Abgleichsergebnis, das durch den Abgleich unter Verwendung des Abgleichsregelfeldes erlangt wird, anzugeben, dass das Abgleichsregelfeld wiederherzustellen ist oder dass die Originaldaten, die zweiten Daten entsprechen, wiederherzustellen sind, wobei die zweiten Daten ein beliebiger Teil von zu dekomprimierenden Daten in der zu dekomprimierenden Datengruppe sind und die zweiten Daten ein oder mehrere Bits sind, die dem Abgleichsregelfeld entsprechen; und
wobei das Verfahren Folgendes umfasst:
Empfangen (401) einer zu dekomprimierenden Datengruppe,
Bestimmen (402) einer Zielabgleichsregel aus der einen oder den mehreren Abgleichsregeln, und
Durchführen (403) von Verarbeiten basierend auf einem voreingestellten Feld, einem Abgleichsregelfeld und einem Dekomprimierungsregelfeld in jedem Abgleichseintrag in der Zielabgleichsregel;
wobei die zu dekomprimierenden Daten eine Angabe umfassen, die angibt, ob eine Komprimierung durchzuführen ist, und eine Kennung der Zielabgleichsregel; und
das Bestimmen einer Zielabgleichsregel aus der einen oder den mehreren Abgleichsregeln Folgendes umfasst:
Bestimmen der Zielabgleichsregel aus der einen oder mehreren Abgleichsregeln basierend auf der Kennung der Zielabgleichsregel in der zu dekomprimierenden Datengruppe;
wobei das voreingestellte Feld einen Zielwert (TV) umfasst;
das Feld Dekomprimierungsregel eine durchzuführende Dekomprimierungsaktion umfasst;
die Dekomprimierungsaktion eines ersten Abgleichseintrags Verwenden eines in der TV des ersten Abgleichseintrags gespeicherten Wertes umfasst;
die Dekomprimierungsaktion eines zweiten Abgleichseintrags Verwenden eines empfangenen Wertes umfasst;
die Dekomprimierungsaktion eines dritten Abgleichseintrags Spleißen des TV des dritten Abgleichseintrags und der niedrigsten y Bits der komprimierten Daten umfasst; und
die Dekomprimierungsaktion eines vierten Abgleichseintrags Verwenden eines Wertes umfasst, der einem Index in einer gemeinsamen Tabelle entspricht.

9. Verfahren nach Anspruch 8, wobei das eine oder die mehreren Bits, die dem voreingestellten Feld entsprechen, Folgendes umfassen:
ein oder mehrere Bits, die in dem voreingestellten Feld enthalten sind und die den ersten Daten entsprechen; oder
ein oder mehrere Bits, die dem Abgleichsergebnis entsprechen, das auf eine bestimmte, dem voreingestellten Feld entsprechende Berechnungsart erlangt wird.

10. Verfahren nach Anspruch 8 oder 9, wobei das eine oder die mehreren Bits, die dem voreingestellten Feld entsprechen, Bits sind, die eine Mindestmenge an Bits der ersten Daten darstellen.

11. Verfahren nach einem der Ansprüche 8 bis 10, wobei jeder Abgleichseintrag ferner ein oder mehrere Datenmerkmalsfelder umfasst und jedes Datenmerkmalsfeld verwendet wird, um ein Datenmerkmal der ersten Daten anzugeben.

12. Verfahren nach einem der Ansprüche 8 bis 11, wobei jeder Abgleichseintrag ferner ein Komprimierungsregelfeld umfasst, das verwendet wird, um basierend auf dem Abgleichsergebnis, das durch den Abgleich unter Verwendung des Abgleichsregelfeldes erlangt wird, anzugeben, dass Daten nicht zu senden sind oder dass ein oder mehrere Bits zu senden sind, wobei, wenn angegeben wird, dass ein oder mehrere Bits zu senden sind, das eine oder die mehreren Bits dem voreingestellten Feld entsprechen; und
wobei das Verfahren ferner Folgendes umfasst:
Empfangen einer abzugleichenden Datengruppe, Erlangen der Zielabgleichsregel durch Durchführen eines Abgleichs basierend auf dem voreingestellten Feld und dem Abgleichsregelfeld in jedem Abgleichseintrag in der einen oder den mehreren Abgleichsregeln und Durchführen von Verarbeiten basierend auf dem Komprimierungsfunktion in jedem Abgleichseintrag in der Zielabgleichsregel, wobei die abzugleichende Datengruppe ein oder mehrere Teile von abzugleichenden Daten umfasst, jedes Teil von abzugleichenden Daten ein oder mehrere Datenbits umfasst und die abzugleichenden Daten die ersten Daten umfassen.

13. Verfahren nach Anspruch 12, wobei
das Komprimierungsregelfeld angibt, dass keine Daten zu senden sind, und das Abgleichsregelfeld ergibt, dass die ersten Daten gleich dem voreingestellten Feld sind; oder
das Komprimierungsregelfeld angibt, dass ein oder mehrere Bits zu senden sind, und das Abgleichsergebnis eines von Folgendem ist: die ersten Daten sind gleich einem von einer Vielzahl von voreingestellten Daten im voreingestellten Feld, ein Teil der ersten Daten ist gleich dem voreingestellten Feld und die ersten Daten und das voreingestellte Feld stimmen mit der spezifischen Berechnungsart überein.

14. Verfahren nach einem der Ansprüche 1 bis 13, wobei die elektronische Vorrichtung eine oder mehrere Schnittstellen umfasst, die dazu konfiguriert sind, eine oder mehrere neue Abgleichsregeln zu empfangen; und die eine oder mehreren neuen Abgleichsregeln basierend auf einem neuen Dienst konfiguriert sind.

15. Elektronische Vorrichtung, wobei die elektronische Vorrichtung einen Prozessor, einen Speicher und eine Kommunikationseinheit umfasst, wobei die Kommunikationseinheit dazu konfiguriert ist, Daten zu empfangen/zu senden, und der Speicher einen Satz von Anweisungen umfasst, die bei Ausführung durch den Prozessor die elektronische Vorrichtung veranlassen, das Verfahren nach einem der Ansprüche 1 bis 14 durchzuführen.

## Revendications

1. Procédé de compression de données destiné à être utilisé dans un dispositif électronique pour envoyer des données compressées, dans lequel le dispositif électronique comprend un processeur et une mémoire, la mémoire stocke une ou plusieurs règles de correspondance, chaque règle de correspondance comprend une ou plusieurs entrées de correspondance, chaque entrée de correspondance est utilisée pour effectuer une correspondance sur des données à faire correspondre dans un groupe de données à faire correspondre, le groupe de données à faire correspondre comprend un ou plusieurs éléments de données à faire correspondre, et chaque élément de données à faire correspondre comprend un ou plusieurs bits de données ;
chaque entrée de correspondance comprend : un champ prédéfini ; un champ de règle de correspondance, utilisé pour indiquer d'effectuer une correspondance entre les premières données dans les données à faire correspondre et le champ prédéfini selon une règle spécifique ; et un champ de règle de compression, utilisé pour indiquer, sur la base d'un résultat de correspondance obtenu par correspondance en utilisant le champ de règle de correspondance, que les données ne doivent pas être envoyées ou qu'un ou plusieurs bits doivent être envoyés, dans lequel lorsqu'un ou plusieurs bits sont indiqués comme devant être envoyés, l'un ou les plusieurs bits sont un ou plusieurs bits correspondant au champ prédéfini ;
dans lequel le champ prédéfini comprend une valeur cible, TV ; dans lequel le champ de règle de correspondance comprend un opérateur de correspondance, MO, configuré pour définir une manière de correspondance entre une valeur de champ, FV, des données à faire correspondre et la TV, et un résultat d'opération est Vrai ou Faux ;
dans lequel le champ de règle de compression comprend une action de compression à effectuer lorsqu'un résultat d'opération d'un opérateur de correspondance associé revient comme étant Vrai ; dans lequel l'opérateur de correspondance d'une première entrée de correspondance comprend un opérateur égal dans lequel le résultat de l'opération est Vrai si la FV est égale à la TV, et l'action de compression comprend le fait de ne pas envoyer les données ;
dans lequel l'opérateur de correspondance d'une deuxième entrée de correspondance comprend un opérateur d'ignorance dans lequel le résultat de l'opération est toujours Vrai, et l'action de compression comprend l'envoi des données ;
dans lequel l'opérateur de correspondance d'une troisième entrée de correspondance comprend une comparaison des x bits les plus élevés de l'opérateur dans lequel le résultat de l'opération est Vrai si les x bits les plus élevés da la FV sont égaux à ceux d'une TV dans une règle, dans lequel le paramètre x est une longueur comparée, et l'action de compression comprend l'envoi des y bits les plus bas des données ; et
dans lequel l'opérateur de correspondance d'une quatrième entrée de correspondance comprend un opérateur de mappage de correspondance dans lequel la TV comprend une liste de valeurs, où chaque valeur de la liste de valeurs est identifiée par un identifiant court, et le résultat de l'opération est Vrai si la FV est égale à l'une des valeurs de la liste de valeurs cibles, et l'action de compression comprend l'envoi d'une valeur d'index de la FV dans la liste de valeurs ; et
le procédé comprend :
la réception (201) d'un groupe de données à faire correspondre, l'obtention (202) d'une règle de correspondance cible en effectuant une correspondance sur la base du champ prédéfini et du champ de règle de correspondance dans chaque entrée de correspondance dans l'une ou les plusieurs règles de correspondance, et
le fait d'effectuer (203) un traitement sur la base d'un champ de règle de compression dans chaque entrée de correspondance dans la règle de correspondance cible ;
dans lequel un groupe de données compressées obtenu après un traitement de compression est effectué sur la base d'un champ prédéfini, d'un champ de règle de correspondance, et le champ de règle de compression dans chaque entrée de correspondance dans la règle de correspondance cible comprend une indication indiquant s'il faut effectuer une compression et un identifiant de la règle de correspondance cible.

2. Procédé selon la revendication 1, dans lequel l'un ou les plusieurs bits correspondant au champ prédéfini comprennent :
un ou plusieurs bits qui sont compris dans le champ prédéfini et qui correspondent aux premières données ; ou
un ou plusieurs bits correspondant au résultat de correspondance obtenu selon une méthode de calcul spécifique correspondant au champ prédéfini.

3. Procédé selon la revendication 1 ou 2, dans lequel l'un ou les plusieurs bits correspondant au champ prédéfini sont des bits représentant une quantité minimale de bits des premières données.

4. Procédé selon l'une quelconque des revendications 1 à 3, dans lequel
le champ de règle de compression indique que les données ne doivent pas être envoyées, et le résultat de correspondance est que les premières données sont égales au champ prédéfini ; ou le champ de règle de compression indique qu'un ou plusieurs bits doivent être envoyés, et le résultat de correspondance est l'un des suivants : les premières données sont égales à l'un d'une pluralité d'éléments de données prédéfinies dans le champ prédéfini, une partie des premières données est égale au champ prédéfini, et les premières données et le champ prédéfini sont conformes à la méthode de calcul spécifique.

5. Procédé selon l'une quelconque des revendications 1 à 4, dans lequel chaque entrée de correspondance comprend également un ou plusieurs champs de caractéristiques de données, et chaque champ de caractéristiques de données est utilisé pour indiquer une caractéristique de données des premières données dans les données à faire correspondre.

6. Procédé selon l'une quelconque des revendications 1 à 5, dans lequel chaque entrée de correspondance comprend également un champ de règle de décompression, utilisé pour indiquer, sur la base du résultat de correspondance obtenu par correspondance à l'aide du champ de règle de correspondance, de restaurer le champ prédéfini ou de restaurer les données d'origine correspondant aux secondes données, dans lequel les secondes données sont de quelconques éléments de données à décompresser d'un groupe de données à décompresser, et les secondes données sont l'un ou les plusieurs bits correspondant au champ prédéfini ; et
le procédé comprend également :
la réception d'un groupe de données à décompresser, la détermination de la règle de correspondance cible à partir de l'une ou des plusieurs règles de correspondance, et le fait d'effectuer un traitement sur la base du champ prédéfini, du champ de règle de correspondance et d'un champ de règle de décompression dans chaque entrée de correspondance dans la règle de correspondance cible.

7. Procédé selon la revendication 6, dans lequel la détermination de la règle de correspondance cible à partir de l'une ou des plusieurs règles de correspondance comprend :
la détermination de la règle de correspondance cible à partir de l'une ou des plusieurs règles de correspondance sur la base de l'identifiant de la règle de correspondance cible dans le groupe de données à décompresser.

8. Procédé de décompression de données destiné à être utilisé dans un dispositif électronique destiné à recevoir des données compressées, dans lequel le dispositif électronique comprend un processeur et une mémoire, la mémoire stocke une ou plusieurs règles de correspondance, chaque règle de correspondance comprend une ou plusieurs entrées de correspondance, et chaque entrée de correspondance est utilisée pour effectuer une correspondance sur des données à décompresser dans un groupe de données à décompresser ;
chaque entrée de correspondance comprend : un champ prédéfini ; un champ de règle de correspondance, utilisé pour indiquer d'effectuer une correspondance entre des premières données de données d'origine et le champ prédéfini selon une règle spécifique ; et un champ de règle de décompression, utilisé pour indiquer, sur la base d'un résultat de correspondance obtenu par correspondance à l'aide du champ de règle de correspondance, de restaurer le champ prédéfini ou de restaurer les données d'origine correspondant aux secondes données, dans lequel les secondes données sont un quelconque élément de données à décompresser dans le groupe de données à décompresser, et les secondes données sont un ou plusieurs bits correspondant au champ prédéfini ; et
le procédé comprend :
la réception (401) d'un groupe de données à décompresser,
la détermination (402) d'une règle de correspondance cible à partir de l'une ou des plusieurs règles de correspondance, et
le fait d'effectuer (403) un traitement sur la base d'un champ prédéfini, d'un champ de règle de correspondance et d'un champ de règle de décompression dans chaque entrée de correspondance dans la règle de correspondance cible ;
dans lequel les données à décompresser comprennent une indication indiquant s'il faut effectuer une compression et un identifiant de la règle de correspondance cible ; et
la détermination d'une règle de correspondance cible à partir de l'une ou des plusieurs règles de correspondance comprend :
la détermination de la règle de correspondance cible à partir de l'une ou des plusieurs règles de correspondance sur la base de l'identifiant de la règle de correspondance cible dans le groupe de données à décompresser ;
dans lequel le champ prédéfini comprend une valeur cible, TV ; le champ de règle de décompression comprend une action de décompression à effectuer ;
l'action de décompression d'une première entrée de correspondance comprend l'utilisation d'une valeur stockée dans la TV de la première entrée de correspondance ;
l'action de décompression d'une deuxième entrée de correspondance comprend l'utilisation d'une valeur reçue ;
l'action de décompression d'une troisième entrée de correspondance comprend l'épissage de la TV de la troisième entrée de correspondance et des y bits les plus bas des données compressées ; et
l'action de décompression d'une quatrième entrée de correspondance comprend l'utilisation d'une valeur correspondant à un index dans une table partagée.

9. Procédé selon la revendication 8, dans lequel l'un ou les plusieurs bits correspondant au champ prédéfini comprennent :
un ou plusieurs bits qui sont compris dans le champ prédéfini et qui correspondent aux premières données ; ou
un ou plusieurs bits correspondant au résultat de correspondance obtenu selon une méthode de calcul spécifique correspondant au champ prédéfini.

10. Procédé selon la revendication 8 ou 9, dans lequel l'un ou les plusieurs bits correspondant au champ prédéfini sont des bits représentant une quantité minimale de bits des premières données.

11. Procédé selon l'une quelconque des revendications 8 à 10, dans lequel chaque entrée de correspondance comprend également un ou plusieurs champs de caractéristiques de données, et chaque champ de caractéristiques de données est utilisé pour indiquer une caractéristique de données des premières données.

12. Procédé selon l'une quelconque des revendications 8 à 11, dans lequel chaque entrée de correspondance comprend également un champ de règle de compression, utilisé pour indiquer, sur la base du résultat de correspondance obtenu par correspondance à l'aide du champ de règle de correspondance, que les données ne doivent pas être envoyées ou qu'un ou plusieurs bits doivent être envoyés, dans lequel lorsqu'un ou plusieurs bits sont indiqués comme devant être envoyés, l'un ou les plusieurs bits sont l'un ou les plusieurs bits correspondant au champ prédéfini ; et
le procédé comprend également :
la réception d'un groupe de données à faire correspondre, l'obtention de la règle de correspondance cible en effectuant une correspondance sur la base du champ prédéfini et du champ de règle de correspondance dans chaque entrée de correspondance dans l'un ou les plusieurs règles de correspondance, et le fait d'effectuer un traitement sur la base du champ de règle de compression dans chaque entrée de correspondance dans la règle de correspondance cible, dans lequel le groupe de données à faire correspondre comprend un ou plusieurs éléments de données à faire correspondre, chaque élément de données à faire correspondre comprend un ou plusieurs bits de données, et les données à faire correspondre comprennent les premières données.

13. Procédé selon la revendication 12, dans lequel
le champ de règle de compression indique que les données ne doivent pas être envoyées, et le résultat de correspondance est que les premières données sont égales au champ prédéfini ; ou
le champ de règle de compression indique qu'un ou plusieurs bits doivent être envoyés, et le résultat de correspondance est l'un des suivants : les premières données sont égales à l'un d'une pluralité d'éléments de données prédéfinies dans le champ prédéfini, une partie des premières données est égale au champ prédéfini, et les premières données et le champ prédéfini sont conformes à la méthode de calcul spécifique.

14. Procédé selon l'une quelconque des revendications 1 à 13, dans lequel le dispositif électronique comprend une ou plusieurs interfaces, configurées pour recevoir une ou plusieurs nouvelles règles de correspondance ; et l'une ou les plusieurs nouvelles règles de correspondance sont configurées sur la base d'un nouveau service.

15. Dispositif électronique, dans lequel le dispositif électronique comprend un processeur, une mémoire et une unité de communication ; dans lequel l'unité de communication est configurée pour recevoir/envoyer des données ; et la mémoire comprenant un ensemble d'instructions, qui, lorsqu'elles sont exécutées par le processeur, amènent le dispositif électronique à effectuer le procédé selon l'une quelconque des revendications 1 à 14.
